# EUROPEAN PATENT APPLICATION

(11) **EP 4 254 503 A1**
(43) Date of publication of application: **04.10.2023**
(21) Application number: 21896662.0
(22) Date of filing: 22.10.2021
(51) Int. Cl.: H01L 29/06, H01L 29/786, H01L 21/336

(54) **CELLULAR STRUCTURE OF SILICON CARBIDE DEVICE, METHOD FOR PREPARATION THEREOF, AND SILICON CARBIDE DEVICE**

(30) Priority: 27.11.2020 CN 202011354573
(71) Applicant: Zhuzhou CRRC Times Semiconductor Co., Ltd., Zhuzhou, Hunan 412005 (CN)
(72) Inventor: WANG, Yafei, Zhuzhou, Hunan 412005 (CN); LUO, Haihui, Zhuzhou, Hunan 412005 (CN); LI, Chengzhan, Zhuzhou, Hunan 412005 (CN); LUO, Yehui, Zhuzhou, Hunan 412005 (CN); ZHANG, Wenjie, Zhuzhou, Hunan 412005 (CN)
(74) Representative: Petraz, Gilberto Luigi
(86) International application number: PCT/CN2021/125473
(87) International publication number: WO 2022/111160

(57) **Abstract**

Provided are a cellular structure of silicon carbide device, a preparation method therefor, and a silicon carbide device, the cellular structure comprising: a plurality of well regions (203) of a second conductive type arranged at intervals in the surface of a drift layer (202); source regions, each located in the surface of the well region (203); gate trenches, each located between two adjacent well regions (203); shielding regions (206) of a second conductive type located within the drift layer (202) and arranged at intervals in a longitudinal direction under the gate trench; wherein, the top of the shielding region (206) is in contact with the bottom of the gate trench and the bottom of the well region (203). Since the shielding regions (206) of the second conductive type are arranged at the bottom of the gate trench at intervals in the longitudinal direction, the electric field stress on a gate dielectric layer of a device in blocking state may be significantly reduced, thereby substantially improving the long-term usage reliability of the device; and since the shielding region (206) is electrically connected with a source metal layer (211), the switching frequency of the device may be improved, thereby reducing switching loss.

## Description

The present disclosure claims the priority of Chinese Patent Application No. 202011354573.6 entitled "Cellular structure of silicon carbide device, preparation method therefor, and silicon carbide device" and filed on November 27, 2020, the content of which is incorporated herein by reference in its entirety.

### Field of the Invention

The present disclosure relates to the technical field of semiconductor devices, in particular to a cellular structure of silicon carbide device, a preparation method therefor, and a silicon carbide device.

### Background of the Invention

With the rise of the market of new energy electric vehicles, a novel wide bandgap semiconductor silicon carbide (SiC) power device has ushered in a rapid development opportunity. This is attributed to the fact that the silicon carbide material has excellent physical, chemical and electrical performances. For example, silicon carbide has a breakdown electric field intensity 10 times higher than that of silicon, and has a thermal conductivity 3 times higher than that of silicon. In particular, silicon carbide metal-oxide-semiconductor field-effect transistor (MOSFET) devices have been commercialized into products by many manufacturers. However, there are still some basic problems in the silicon carbide power devices (MOSFET), especially a planar gate silicon carbide power device (MOSFET), that there are a lot of defects at the interface between silicon carbide and a gate dielectric layer such that a channel carrier mobility is greatly reduced.

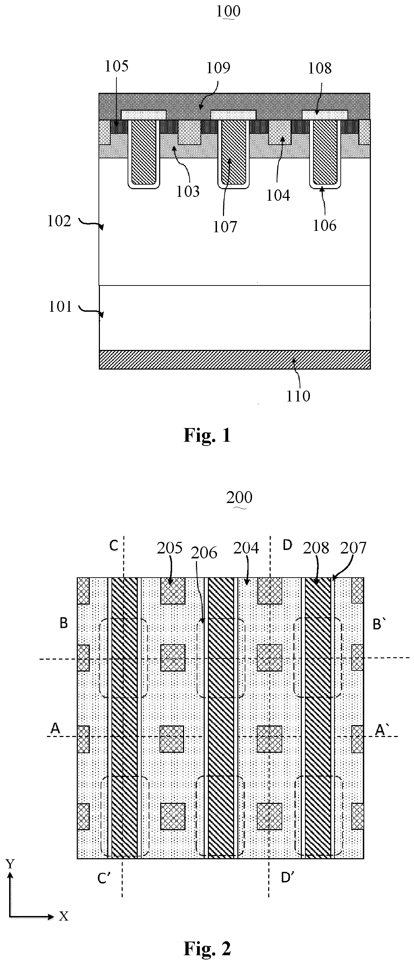

A trench gate silicon carbide power device (MOSFET) can utilize the anisotropy of silicon carbide material by using a crystal plane near (11 20) to achieve a relatively high channel carrier mobility. A cellular structure 100 of a conventional trench gate silicon carbide power device (MOSFET) is shown in Fig. 1, comprising a substrate 101, a drift layer 102, well regions 103, first source regions 104, second source regions 105, gate dielectric layers 106, gates 107, interlayer dielectric layers 108, a source metal layer 109 and a drain metal layer 110. However, in the trench gate silicon carbide power device (MOSFET), the electric field intensity in a gate dielectric layer is 2.5 times higher than an electric field peak value in silicon carbide according to the Gauss law due to difference of dielectric constants between the silicon carbide material and the gate dielectric layer material, and the silicon carbide material itself has a relatively high critical breakdown electric field. As a result, an excessive electric field stress in the gate dielectric layer has been caused, thereby affecting the long-term reliability of the device and even causing failure of the device.

### Summary of the Invention

In view of the above problems, the present disclosure provides a cellular structure of silicon carbide device, a preparation method therefor, and a silicon carbide device, which can solve the technical problems of device failure and poor reliability of a silicon carbide device in a blocking state due to damage of a gate dielectric layer caused by an electric field stress in the prior art.

In a first aspect, the present disclosure provides a cellular structure of silicon carbide device, comprising:
a silicon carbide substrate of a first conductive type;
a drift layer of the first conductive type located above the substrate;
a plurality of well regions of a second conductive type which are arranged in a surface of the drift layer at intervals;
source regions, a source region of which is located in a surface of a well region;
gate trenches, a gate trench of which is positioned between two adjacent well regions; wherein a side wall of the gate trench is in contact with both the well region and the source region, and a depth of the gate trench is greater than a depth of the well region; and
shielding regions of the second conductive type, which are located within the drift layer and arranged under the gate trench at intervals in a longitudinal direction; wherein top of a shielding region is in contact with bottom of the gate trench and bottom of the well regions.

According to an embodiment of the present disclosure, preferably, the source region include a first source region of the first conductive type and second source regions of the second conductive type which are arranged in the first source region at intervals in the longitudinal direction;
wherein the first source region has its both ends in contact with side walls of gate trenches on both sides, respectively, and the second source regions are not in contact with the side walls of the gate trenches.

According to an embodiment of the present disclosure, preferably, the shielding regions under two adjacent gate trenches are arranged to be staggered from each other.

According to an embodiment of the present disclosure, preferably, the cellular structure further comprises:
storage regions of the first conductive type which are located under the gate trench;
wherein the storage regions and the shielding regions are arranged to be alternated with each other in the longitudinal direction, and top of a storage region is in contact with bottom of the gate trench and bottom of the well regions.

According to an embodiment of the present disclosure, preferably,
the shielding regions under two adjacent gate trenches are arranged to be aligned with each other.

According to an embodiment of the present disclosure, preferably, the source region include first source regions of the first conductive type and second source regions of the second conductive type, which two are arranged to be alternated with each other in the longitudinal direction;
wherein the second source regions and the shielding regions are arranged to be aligned with each other in a transverse direction, and a first source region/a second source region has its both ends in contact with side walls of gate trenches on both sides.

According to an embodiment of the present disclosure, preferably, the depth of the gate trench is 0.4 to 2.0 µm; and
a width of the gate trench is 0.15 to 3.0 µm.

According to an embodiment of the present disclosure, preferably,
an ion doping concentration of the shielding region is greater than 1E15 cm⁻³; and
a depth of the shielding region is 0.2 to 5 µm_{∘}

According to an embodiment of the present disclosure, preferably, the cellular structure further comprises:
gate dielectric layers, a gate dielectric layer of which is arranged on side walls and bottom of the gate trench; and gates, a gate of which is filled in the gate trench;
a source metal layer located above the source regions and electrically connected with the source regions; wherein the gates are isolated from the source metal layer through interlayer dielectric layers, and the shielding regions are electrically connected with the source metal layer through the well regions and the source regions; and
a drain metal layer located under the substrate and forming an ohmic contact with the substrate.

In a second aspect, the present disclosure provides a method for preparing the cellular structure of silicon carbide device, comprising steps of:
providing a silicon carbide substrate of a first conductive type;
forming a drift layer of the first conductive type above the substrate;
forming a plurality of well regions of a second conductive type which are arranged at intervals in a surface of the drift layer;
forming a source region in a surface of a well region;
forming a gate trench between two adjacent well regions; wherein a side wall of the gate trench is in contact with both the well region and the source region, and a depth of the gate trench is greater than a depth of the well region; and
forming, by inclined ion injection, within the drift layer and under the gate trench shielding regions of the second conductive type which are arranged at intervals in a longitudinal direction; wherein top of a shielding region is in contact with bottom of the gate trench and bottom of the well regions.

According to an embodiment of the present disclosure, preferably, the source region includes a first source region of the first conductive type and second source regions of the second conductive type which are arranged in the first source region at intervals in the longitudinal direction; and the step of forming a source region in a surface of a well region comprises steps of:
forming a first source region of the first conductive type in a surface of the well region; wherein the first source region has its both ends in contact with side walls of gate trenches on both sides, respectively; and
forming second source regions of the second conductive type which are arranged in the first source region at intervals in the longitudinal direction; wherein the second source regions are not in contact with the side walls of the gate trenches.

According to an embodiment of the present disclosure, preferably, the shielding regions under two adjacent gate trenches are arranged to be staggered with each other.

According to an embodiment of the present disclosure, preferably, after the step of forming, by inclined ion injection, within the drift layer and under the gate trench shielding regions of the second conductive type which are arranged at intervals in a longitudinal direction, the method further comprises:
forming storage regions of the first conductive type under the gate trench;
wherein the storage regions and the shielding regions are arranged to be alternated with each other in the longitudinal direction, and top of a storage region is in contact with bottom of the gate trench and bottom of the well regions.

According to an embodiment of the present disclosure, preferably, the shielding regions under two adjacent gate trenches are arranged to be aligned with each other.

According to the embodiment of the present disclosure, preferably, the source region includes first source regions of the first conductive type and second source regions of the second conductive type, which two are arranged to be alternated with each other in the longitudinal direction; and the step of forming a source region in a surface of a well region comprises steps of:
forming, in a surface of the well region, first source regions of the first conductive type and second source regions of the second conductive type, which two are arranged to be alternated with each other in the longitudinal direction;
wherein the second source regions and the shielding regions are arranged to be aligned with each other in a transverse direction, and a first source region/a second source region has its both ends in contact with side walls of gate trenches on both sides.

According to an embodiment of the present disclosure, preferably, after the step of forming, by inclined ion injection, within the drift layer and under the gate trench shielding regions of the second conductive type which are arranged at intervals in a longitudinal direction, the method further comprises:
forming a gate dielectric layer on side walls and bottom of the gate trench;
filling polysilicon into the gate trench to form a gate;
forming, above the gate, an interlayer dielectric layer covering the gate;
forming, above the source region, a source metal layer which is electrically connected with the source region; wherein the gate is isolated from the source metal layer through an interlayer dielectric layer, and the shielding region is electrically connected with the source metal layer through the well region and the source region; and
forming, under the substrate, a drain metal layer which is in ohmic contact with the substrate.

In a third aspect, the present disclosure provides a silicon carbide device, which comprises a plurality of the cellular structures of silicon carbide device as described in any one item of the first aspect.

With the above technical solution, at least the following technical effects can be achieved:
(1) By arranging at the bottom of the gate trench the shielding regions of the second conductive type which are arranged at intervals in the longitudinal direction, it is possible to greatly reduce an electric field stress of the gate dielectric layer of the device in a blocking state, and thus greatly improve the long-term use reliability of the device;
(2) By contacting the shielding region with the bottom of the well regions, the shielding region can be electrically connected with the source metal layer through the well regions and the source regions (the second source regions of the second conductive type), such that a switching frequency of the device is improved and the switching loss is reduced;
(3) By arranging at the bottom of the gate trench the shielding regions which are arranged at intervals in the longitudinal direction, it is possible to separate an electrical conduction region (a part of the trench where no shielding region is located at the bottom) from an electric field protection region (a part of the trench where a shielding region is located at the bottom); and the formation process of the shielding regions affects neither an ion doping concentration in the electrical conduction region (on the surface of the trench) nor the electrical characteristics of the device such as a threshold voltage and the like, thereby facilitating current equalization among cells; and
(4) The preparation process has a simple manufacturing process, a high manufacturability and a low manufacturing cost.

### Brief Description of the Drawings

The accompanying drawings are intended to provide a further understanding of the present disclosure, and constitute a part of the description to explain the present disclosure together with the following detailed description of the embodiments, rather than limitation to the present disclosure, in which:
Fig. 1 is a schematic diagram of a cross-sectional structure of a conventional cellular structure of silicon carbide device;
Fig. 2 is a schematic top view of the observe side of a cellular structure of silicon carbide device illustrated in an exemplary embodiment of the present disclosure;
Fig. 3 is a schematic diagram of a cross-sectional structure of a cellular structure of silicon carbide device illustrated in an exemplary embodiment of the present disclosure;
Fig. 4 is a schematic top view of the observe side of another cellular structure of silicon carbide device illustrated in an exemplary embodiment of the present disclosure;
Fig. 5 is a schematic diagram of a cross-sectional structure of another cellular structure of silicon carbide device illustrated in an exemplary embodiment of the present disclosure;
Fig. 6 is a schematic top view of the observe side of another cellular structure of silicon carbide device illustrated in an exemplary embodiment of the present disclosure;
Fig. 7 is a schematic diagram of a cross-sectional structure of another cellular structure of silicon carbide device illustrated in an exemplary embodiment of the present disclosure;
Fig. 8 is a schematic top view of the observe side of another cellular structure of silicon carbide device illustrated in an exemplary embodiment of the present disclosure;
Fig. 9 is a schematic diagram of a cross-sectional structure of another cellular structure of silicon carbide device illustrated in an exemplary embodiment of the present disclosure;
Fig. 10 is a schematic flow diagram of a method for preparing a cellular structure of silicon carbide device illustrated in an exemplary embodiment of the present disclosure;
Figs. 11-15 are schematic diagrams of cross-sectional structures formed by related steps of a method for preparing a cellular structure of silicon carbide device illustrated in an exemplary embodiment of the present disclosure;
Fig. 16 is a schematic flow diagram of a method for preparing another cellular structure of silicon carbide device illustrated in an exemplary embodiment of the present disclosure; and
Fig. 17 is a schematic flow diagram of a method for preparing another cellular structure of silicon carbide device illustrated in an exemplary embodiment of the present disclosure.

In the accompanying drawings, identical components are indicated by the same reference number, and the drawings are not drawn according to an actual scale.

### Detailed Description of the Embodiments

Hereafter, the implementations of the present disclosure will be described in detail in conjunction with the accompanying drawings and embodiments, whereby the implementation process of how the technical means is applied in the present disclosure to solve the technical problems and achieve the corresponding technical effects may be fully understood and implemented. The embodiments of the present disclosure and the individual features in the embodiments may be combined with each other as long as no conflict is resulted, and all of the technical solutions formed therefrom fall into the protection scope of the present disclosure. In the accompanying drawings, the dimensions of layers and regions as well as the relative dimension between a layer and a region may be exaggerated for clarity. The same reference number indicates identical components throughout the accompanying drawings.

It should be understood that, although the terms "first", "second", "third", etc. may be used to describe various elements, components, regions, layers and/or parts, they should not be deemed as limitation to these elements, components, regions, layers and/or parts. These terms are only used to distinguish one element, component, region, layer or part from another element, component, region, layer or part. Therefore, a first element, component, region, layer or part discussed below may be represented as a second element, component, region, layer or part without departing from the teaching of the present disclosure.

It should be understood that, for convenience of description, the spatial relationship terms such as "above", "located above...", "under", "located under...", etc. may be used here to describe the relationship between one element or feature and other elements or features shown in the drawings. It should be understood that, in addition to the orientations shown in the drawings, the spatial relationship terms are intended to include different orientations of a device in use and operation. For example, if a device in the drawings is turned over, the elements or features described as "below other elements" will be oriented as "above" other elements or features. As a result, the exemplary terms "under" and "below" may include both upper and lower orientations. The device may be additionally oriented (rotated by 90 degrees or in other orientations) and the terms for spatial description used herein should be interpreted accordingly.

The terms used herein are only intended to describe specific embodiments without limiting the present disclosure. As used herein, the singular forms "a", "an" and "said/the" are also intended to include plural references unless the context clearly dictates otherwise. It should also be understood that the terms "comprise" and/or "include", as used in this description, confirm the presence of the stated features, integers, steps, operations, elements and/or components, but do not exclude the presence or addition of another one or more feature(s), integer(s), step(s), operation(s), element(s), component(s) and/or group(s) thereof. As used herein, the term "and/or" includes any combinations among related items listed and a combination of them all.

The embodiments of the present disclosure are described here with reference to cross-sectional views that serve as schematic diagrams of ideal embodiments (and intermediate-stage structures thereof) of the present disclosure. In this way, changes from the shown shapes due to, for example, preparation techniques and/or tolerances can be expected. Therefore, the embodiments of the present disclosure should not be limited to the specific shapes of those regions shown herein, but shape deviations due to, for example, preparation are included therein. For example, an injection region shown with a rectangle shape usually has round or curved features and/or an injection concentration gradient at the edge thereof, rather than having a sharp change from the injection region to a non-injection region. Also, a buried region formed by injection may result in some injections in regions between the buried region and a surface which is passed through when the injection is carried out. Therefore, the regions shown in the drawings are schematic in nature, and their shapes are intended neither to exhibit the actual shapes of the regions of the device, nor to limit the scope of the present disclosure.

In order to facilitate full understanding of the present disclosure, detailed structures and steps will be presented in the following description to illustrate the technical solutions proposed in the present disclosure. The preferred embodiments of the present disclosure are described in detail as follows. However, in addition to these detailed descriptions, the present disclosure may also comprise other implementations.

### Embodiment 1

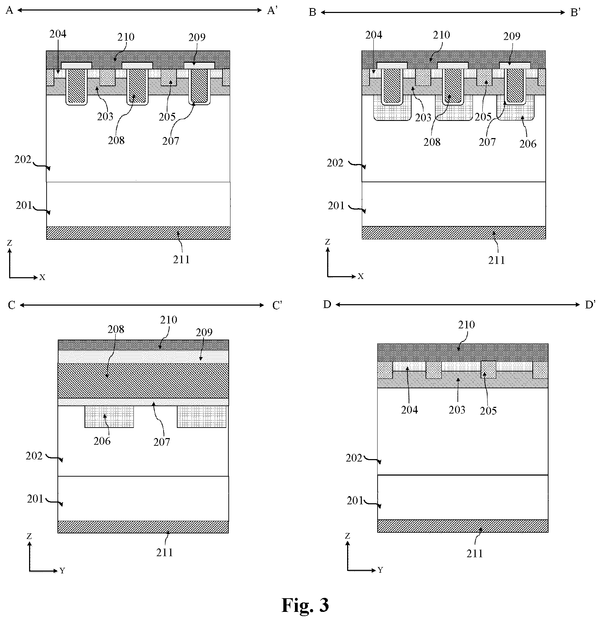

As shown in Figs. 2 and 3, an embodiment of the present disclosure provides a cellular structure 200 of silicon carbide device, comprising a substrate 201, a drift layer 202, well regions 203, source regions (not denoted in the figure), shielding regions 206, gate trenches (not denoted in the figure), gate dielectric layers 207, gates 208, interlayer dielectric layers 209, a source metal layer 210 and a drain metal layer 211.

It should be noted that, in this embodiment, in the following, the term "transverse direction" refers to "X direction", the term "longitudinal direction" refers to "Y direction", the term "width" refers to "a width in X direction", and the term "depth" refers to "a depth in Z direction".

It should be noted that, in order to clearly show the shapes and positions of the source regions (not denoted in the figure), the shielding regions 206, the gate trenches (not denoted in the figure), the gate dielectric layers 207 and the gates 208 in Fig. 2, the substrate 201, the drift layer 202, the well regions 203, the interlayer dielectric layers 209, the source metal layer 210 and the drain metal layer 211 are not shown in Fig. 2. Instead, the shapes and positions of the substrate 201, the drift layer 202, the well regions 203, the interlayer dielectric layers 209, the source metal layer 210 and the drain metal layer 211 may be comprehended in conjunction with Fig. 3.

By way of example, the substrate 201 is a silicon carbide substrate 201 of a first conductive type. The substrate 201 has a relatively large thickness and a relatively high ion doping concentration, with an ion doping concentration of greater than 1E18 cm⁻³.

The drift layer 202 is a drift layer 202 of the first conductive type, which is located above the substrate 201. The drift layer 202 has an ion doping concentration of about 1E14 to 5E16 cm⁻³. The ion doping concentration and a thickness of the drift layer 202 need to be optimized according to a withstand voltage of a chip.

A well region 203 is a well region 203 of a second conductive type. A plurality of well regions 203 are arranged in the surface of the drift layer 202 at intervals. The upper surface of the well region 203 is flush with the upper surface of the drift layer 202. The well region 203 has an ion doping concentration of 1E16 to 1E18 cm⁻³ and a depth of 0.3 to 1.5 µm_{∘}

A source region is located in the surface of the well region 203. In this embodiment, the source region includes a first source region 204 and second source regions 205.

The first source region 204 is a source region of the first conductive type, and is located in the surface of a well region 203. The upper surface of the first source region 204 is flush with the upper surface of the well region 203. The first source region 204 has its both ends in contact with side walls of gate trenches at both sides of the first source region. A width of the first source region 204 is equal to a width of the well region 203, and a depth of the first source region 204 is less than the depth of the well region 203. The first source region 204 has an ion doping concentration of greater than 1E19 cm⁻³ and a depth of 0.2 to 0.5 µm_{∘}

A second source region 205 is a source region of the second conductive type. The second source regions 205 are arranged in the first source region 204 at intervals in a longitudinal direction (Y direction). The upper surface of the second source region 205 is flush with the upper surface of the well region 203. The second source region 205 is not in contact with the side walls of the gate trenches. A width of the second source region 205 is less than the width of the first source region 204. A depth of the second source region 205 is greater than the depth of the first source region 204, but is less than the depth of the well region 203. An ion doping concentration of the second source region 205 is greater than the ion doping concentration of the well region 203. The second source region 205 has an ion doping concentration of greater than 5E18 cm⁻³ and a depth of 0.3 to 1.5 µm_{∘}

A gate trench (not denoted in the figure) is located between two adjacent well regions 203, and a side wall of the gate trench is in contact with both a well region 203 and a first source region 204 in a source region. A depth of the gate trench is greater than the depth of the well region 203. The depth of the gate trench is 0.4 to 2.0 µm, and a width of the gate trench is 0.15 to 3.0 µm_{∘}

A gate dielectric layer 207 is uniformly arranged on side walls and the bottom of the gate trench. The gate dielectric layer 207 may be an oxidation layer with a thickness of about 30 nm to 1000 nm. The thickness of the dielectric layer at the bottom of the trench can be greater than the thickness of the dielectric layer on the side walls so as to improve the withstand voltage capability of the bottom of the gate dielectric layer 207.

Gate 208 is polysilicon gate of the first conductive type, which is arranged within the gate trench and has an ion doping concentration of greater than 1E18 cm⁻³.

A shielding region 206 is a doped region of the second conductive type. The shielding regions 206 are located within the drift layer 202 and are arranged under the gate trench at intervals in the longitudinal direction (Y direction). The top of the shielding region 206 is in contact with the bottom of a gate trench and the bottom of well regions 203. An ion doping concentration of the shielding region 206 is greater than 1E15 cm⁻³, and a junction depth (the depth) of the shielding region 206 is 0.2 to 5 µm_{∘}

In this embodiment, the shielding regions 206 under two adjacent gate trenches are arranged to be aligned with each another.

The shielding region 206 can greatly reduce an electric field stress of the gate dielectric layer 207 of a device in a blocking state, thereby greatly improving the long-term use reliability of the device.

Further, since that the top of the shielding region 206 is in contact with the bottom of the gate trench and the bottom of the well regions 203 and that the first source regions 204 and the second source regions 205 in the surface of the well regions 203 are electrically connected with the source metal layer 210, the shielding region 206 is in electrical connection (short-circuited connection) with the source metal layer 210 through the well regions 203 and the second source regions 205, such that a switching frequency of the device can be improved and switching loss can be reduced.

Since the shielding regions 206 are arranged at the bottom of the gate trench at intervals in the longitudinal direction and are in short-circuited connection with the source metal layer 210, at a portion of a trench gate (including the gate trench, a gate dielectric layer 207 and gate 208) where a shielding region 206 is involved, no channel is formed on either side of the trench gate, and thus there is no channel current (conduction current) generated, but at a portion of the trench gate where no shielding region 206 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 207 in the blocking state. Further, the formation process of the shielding regions 206 affects neither an ion doping concentration in the electrical conduction region (on the surface of the trench) nor the electrical characteristics of the device such as a threshold voltage and the like, thereby facilitating current equalization among cells.

Also, since the top of the shielding region 206 is in contact with the bottom of the gate trench and the bottom of the well regions 203, a problem of process difficulty in the prior art caused by the fact that the shielding region is not allowed to contact the well regions and a certain etching depth is required for the gate trench can be overcome.

An interlayer dielectric layer 209 is located above the gate 208, and the interlayer dielectric layer 209 separates the gate 208 from the source metal layer 210.

The source metal layer 210 is located above the source regions (including the first source regions 204 and the second source regions 205), and is electrically connected with both the first source regions 204 and the second source regions 205. The source metal layer 210 may be made of a metal such as aluminum, nickel and the like which has a low contact resistivity with SiC.

The drain metal layer 211 is located under the substrate 201 and forms an ohmic contact with the substrate 201. Metal of drain may be a metal such as aluminum, nickel and the like which has a low contact resistivity with SiC.

It should be noted that, the silicon carbide device in this embodiment is a trench gate silicon carbide MOSFET device.

Correspondingly, the first conductive type is opposite to the second conductive type. For example, in the case that the first conductive type is N type, the second conductive type is P type; and in the case that the first conductive type is P type, the second conductive type is N type.

This embodiment provides a cellular structure 200 of silicon carbide device, in which by forming the shielding regions 206 of the second conductive type which are arranged at intervals in the longitudinal direction at the bottom of the gate trench, it is possible to greatly reduce the electric field stress of the gate dielectric layer 207 of the device in a blocking state, and thus greatly improve the long-term use reliability of the device; by contacting the shielding region 206 with the bottom of the well regions 203, the shielding region 206 can be electrically connected with the source metal layer 210 through the well regions 203 and the source regions, such that the switching frequency of the device is improved and the switching loss is reduced; and by providing the shielding regions 206 which are arranged at intervals in the longitudinal direction, it is possible to separate the electrical conduction region from the electric field protection region, and the formation process of the shielding regions 206 affects neither the ion doping concentration in the electrical conduction region nor the electrical characteristics of the device such as a threshold voltage and the like, thereby facilitating current equalization among cells.

### Embodiment 2

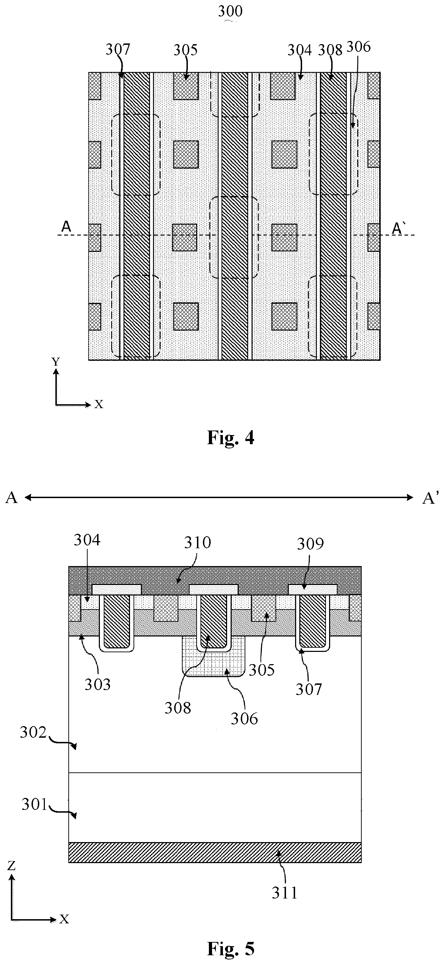

As shown in Figs. 4 and 5, an embodiment of the present disclosure provides a cellular structure 300 of silicon carbide device, comprising a substrate 301, a drift layer 302, well regions 303, source regions (not denoted in the figure), shielding regions 306, gate trenches (not denoted in the figure), gate dielectric layers 307, gates 308, interlayer dielectric layers 309, a source metal layer 310 and a drain metal layer 311.

It should be noted that, in this embodiment, in the following, the term "transverse direction" refers to "X direction", the term "longitudinal direction" refers to "Y direction", the term "width" refers to "a width in X direction", and the term "depth" refers to "a depth in Z direction".

It should be noted that, in order to clearly show the shapes and positions of the source regions (not denoted in the figure), the shielding regions 306, the gate trenches (not denoted in the figure), the gate dielectric layers 307 and the gates 308 in Fig. 4, the substrate 301, the drift layer 302, the well regions 303, the interlayer dielectric layers 309, the source metal layer 310 and the drain metal layer 311 are not shown in Fig. 4. Instead, the shapes and positions of the substrate 301, the drift layer 302, the well regions 303, the interlayer dielectric layers 309, the source metal layer 310 and the drain metal layer 311 may be comprehended in conjunction with Fig. 5.

By way of example, the substrate 301 is a silicon carbide substrate 301 of a first conductive type. The substrate 301 has a relatively large thickness and a relatively high ion doping concentration, with an ion doping concentration of greater than 1E18 cm⁻³.

The drift layer 302 is a drift layer 302 of the first conductive type, which is located above the substrate 301. The drift layer 302 has an ion doping concentration of about 1E14 to 5E16 cm⁻³. The ion doping concentration and a thickness of the drift layer 302 need to be optimized according to a withstand voltage of a chip.

A well region 303 is a well region 303 of a second conductive type. A plurality of well regions 303 are arranged in the surface of the drift layer 302 at intervals. The upper surface of the well region 303 is flush with the upper surface of the drift layer 302. The well region 303 has an ion doping concentration of 1E16 to 1E18 cm⁻³ and a depth of 0.3 to 1.5 µm_{∘}

A source region is located in the surface of the well region 303. In this embodiment, the source region includes a first source region 304 and second source regions 305.

The first source region 304 is a source region of the first conductive type. The first source region 304 is located in the surface of a well region 303. The upper surface of the first source region 304 is flush with the upper surface of the well region 303. The first source region 304 has its both ends in contact with side walls of gate trenches arranged at both sides of the first source region. A width of the first source region 304 is equal to a width of the well region 303, and a depth of the first source region 304 is less than the depth of the well region 303. The first source region 304 has an ion doping concentration of greater than 1E19 cm⁻³ and a depth of 0.2 to 0.5 µm_{∘}

A second source region 305 is a source region of the second conductive type. The second source regions 305 are arranged in the first source regions 304 at intervals in the longitudinal direction (Y direction). The upper surface of the second source region 305 is flush with the upper surface of the well region 303. The second source region 305 is not in contact with the side walls of the gate trenches. A width of the second source region 305 is less than the width of the first source region 304. A depth of the second source region 305 is greater than the depth of the first source region 304, but is less than the depth of the well region 303. An ion doping concentration of the second source region 305 is greater than the ion doping concentration of the well region 303. The second source region 305 has an ion doping concentration of greater than 5E18 cm⁻³ and a depth of 0.3 to 1.5 µm_{∘}

A gate trench (not denoted in the figure) is located between two adjacent well regions 303, and a side wall of the gate trench is in contact with both a well region 303 and a first source region 304 in a source region. A depth of the gate trench is greater than the depth of the well region 303. The depth of the gate trench is 0.4 to 2.0 µm, and a width of the gate trench is 0.15 to 3.0 µm_{∘}

A gate dielectric layer 307 is uniformly arranged on side walls and the bottom of the gate trench. The gate dielectric layer 307 may be an oxidation layer with a thickness of about 30 nm to 1000 nm. The thickness of the dielectric layer at the bottom of the trench can be greater than the thickness of the dielectric layer on the side walls so as to improve the withstand voltage capability of the bottom of the gate dielectric layer 307.

Gate 308 is polysilicon gate of the first conductive type, which is arranged within the gate trench, and has an ion doping concentration of greater than 1E18 cm⁻³.

A shielding region 306 is a doped region of the second conductive type. The shielding regions 306 are located within the drift layer 302 and are arranged under the gate trench at intervals in the longitudinal direction (Y direction). The top of the shielding region 306 is in contact with the bottom of a gate trench and the bottom of well regions 303. An ion doping concentration of the shielding region 306 is greater than 1E15 cm⁻³, and a junction depth (the depth) of the shielding region 306 is 0.2 to 5 µm_{∘}

In this embodiment, the shielding regions 306 under two adjacent gate trenches are arranged to be staggered from each other.

The shielding region 306 can greatly reduce an electric field stress of the gate dielectric layer 307 of a device in a blocking state, thereby greatly improving the long-term use reliability of the device.

Further, since that the top of the shielding region 306 is in contact with the bottom of a gate trench and the bottom of the well regions 303 and that the first source regions 304 and the second source regions 305 in the surface of the well regions 303 are electrically connected with the source metal layer 310, the shielding region 306 is in electrical connection (short-circuited connection) with the source metal layer 310 through the well regions 303 and the second source regions 305, such that a switching frequency of the device can be improved and switching loss can be reduced.

Since the shielding regions 306 are arranged at the bottom of the gate trench at intervals in the longitudinal direction and are in short-circuited connection with the source metal layer 310, at a portion of a trench gate (including the gate trench, a gate dielectric layer 307 and gate 308) where a shielding region 306 is involved, no channels is formed on either side of the trench gate, and thus there is no channel current (conduction current) generated, but at a portion of the trench gate where no shielding region 306 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 307 in the blocking state. Further, the formation process of the shielding regions 306 affects neither an ion doping concentration in the electrical conduction region (on the surface of the trench) nor the electrical characteristics of the device such as a threshold voltage and the like, thereby facilitating current equalization among cells.

Compared with the shielding regions which are arranged to be aligned in Embodiment 2, the shielding regions 306 which are arranged to be staggered from each other in this embodiment allow the electric field protection regions and the electrical conduction regions to be arranged in a staggered manner in the entire silicon carbide device. The shielding regions 306 are utilized to shield electric fields around them, such that the electric field stress of the gate dielectric layer 307 is further reduced while the area of the electrical conduction regions is increased, thereby achieving a better compromise between current conduction and voltage blocking.

Also, since the top of the shielding region 306 is in contact with the bottom of the gate trench and the bottom of the well regions 303, a problem of process difficulty in the prior art caused by the fact that the shielding region is not allowed to contact the well regions and a certain etching depth is required for the gate trench can be overcome.

An interlayer dielectric layer 309 is located above the gate 308, and the interlayer dielectric layer 309 separates the gate 308 from the source metal layer 310.

The source metal layer 310 is located above the source regions (including the first source regions 304 and the second source regions 305), and is electrically connected with both the first source regions 304 and the second source regions 305. The source metal layer 310 may be made of a metal such as aluminum, nickel and the like which has a low contact resistivity with SiC.

The drain metal layer 311 is located under the substrate 301 and forms an ohmic contact with the substrate 301. Metal of drain may be a metal such as aluminum, nickel and the like which has a low contact resistivity with SiC.

It should be noted that, the silicon carbide device in this embodiment is a trench gate silicon carbide MOSFET device.

Correspondingly, the first conductive type is opposite to the second conductive type. For example, in the case that the first conductive type is N type, the second conductive type is P type; and in the case that the first conductive type is P type, the second conductive type is N type.

This embodiment provides a cellular structure 300 of silicon carbide device, in which by forming the shielding regions 306 of the second conductive type which are arranged at intervals in the longitudinal direction at the bottom of the gate trench, it is possible to greatly reduce the electric field stress of the gate dielectric layer 307 of the device in a blocking state, and thus greatly improve the long-term use reliability of the device; by contacting the shielding region 306 with the bottom of the well regions 303, the shielding region 306 can be electrically connected with the source metal layer 310 through the well regions 303 and the source regions, such that the switching frequency of the device is improved and the switching loss is reduced; and by providing the shielding regions 306 which are arranged at intervals in the longitudinal direction, it is possible to separate the electrical conduction region from the electric field protection region, and the formation process of the shielding regions 306 affects neither the ion doping concentration in the electrical conduction region nor the electrical characteristics of the device such as a threshold voltage and the like, thereby facilitating current equalization among cells.

### Embodiment 3

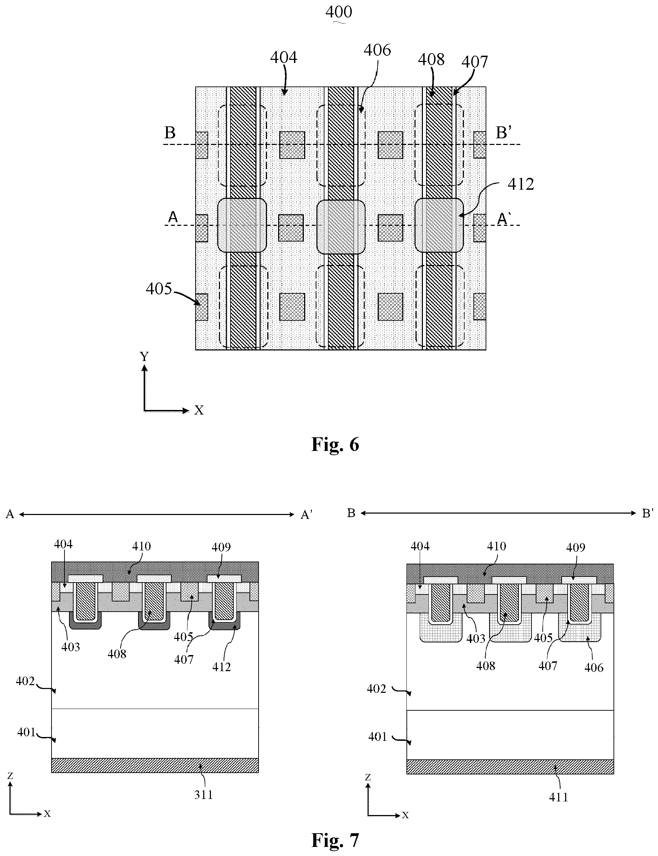

As shown in Figs. 6 and 7, an embodiment of the present disclosure provides a cellular structure 400 of silicon carbide device, comprising a substrate 401, a drift layer 402, well regions 403, source regions (not denoted in the figure), shielding regions 406, storage regions 412, gate trenches (not denoted in the figure), gate dielectric layers 407, gates 408, interlayer dielectric layers 409, a source metal layer 410 and a drain metal layer 411.

It should be noted that, in this embodiment, in the following, the term "transverse direction" refers to "X direction", the term "longitudinal direction" refers to "Y direction", the term "width" refers to "a width in X direction", and the term "depth" refers to "a depth in Z direction".

It should be noted that, in order to clearly show the shapes and positions of the source regions (not denoted in the figure), the shielding regions 406, the gate trenches (not denoted in the figure), the gate dielectric layers 407 and the gates 408 in Fig. 6, the substrate 401, the drift layer 402, the well regions 403, the interlayer dielectric layers 409, the source metal layer 410 and the drain metal layer 411 are not shown in Fig. 6. Instead, the shapes and positions of the substrate 401, the drift layer 402, the well regions 403, the interlayer dielectric layers 409, the source metal layer 410 and the drain metal layer 411 may be comprehended in conjunction with Fig. 7.

By way of example, the substrate 401 is a silicon carbide substrate 401 of a first conductive type. The substrate 401 has a relatively large thickness and a relatively high ion doping concentration, with an ion doping concentration of greater than 1E18 cm⁻³.

The drift layer 402 is a drift layer 402 of the first conductive type, which is located above the substrate 401. The drift layer 402 has an ion doping concentration of about 1E14 to 5E16 cm⁻³. The ion doping concentration and a thickness of the drift layer 402 need to be optimized according to a withstand voltage of a chip.

A well region 403 is a well region 403 of a second conductive type. A plurality of well regions 403 are arranged in the surface of the drift layer 402 at intervals. The upper surface of the well region 403 is flush with the upper surface of the drift layer 402. The well region 403 has an ion doping concentration of 1E16 to 1E18 cm⁻³ and a depth of 0.3 to 1.5 µm_{∘}

A source region is located in the surface of the well region 403. In this embodiment, the source region includes a first source region 404 and second source regions 405.

The first source region 404 is a source region of the first conductive type. The first source region 404 is located in the surface of a well region 403. The upper surface of the first source region 404 is flush with the upper surface of the well region 403. The first source region 404 has its both ends in contact with side walls of gate trenches at both sides of the first source region. A width of the first source region 404 is equal to a width of the well region 403, and a depth of the first source region 404 is less than the depth of the well region 403. The first source region 404 has an ion doping concentration of greater than 1E19 cm⁻³ and a depth of 0.2 to 0.5 µm_{∘}

A second source region 405 is a source region of the second conductive type. The second source regions 405 are arranged in the first source regions 404 at intervals in the longitudinal direction (Y direction). The upper surface of the second source region 405 is flush with the upper surface of the well region 403. The second source region 405 is not in contact with the side walls of the gate trenches. A width of the second source region 405 is less than the width of the first source region 404. A depth of the second source region 405 is greater than the depth of the first source region 404, but is less than the depth of the well region 403. An ion doping concentration of the second source region 405 is greater than the ion doping concentration of the well region 403. The second source region 405 has an ion doping concentration of greater than 5E18 cm⁻³ and a depth of 0.3 to 1.5 µm_{∘}

A gate trench (not denoted in the figure) is located between two adjacent well regions 403, and a side wall of the gate trench is in contact with both a well region 403 and a first source region 404 in a source region. A depth of the gate trench is greater than the depth of the well region 403. The depth of the gate trench is 0.4 to 2.0 µm, and a width of the gate trench is 0.15 to 3.0 µm_{∘}

A gate dielectric layer 407 is uniformly arranged on side walls and the bottom of the gate trench. The gate dielectric layer 407 may be an oxidation layer with a thickness of about 30 nm to 1000 nm. The thickness of the dielectric layer at the bottom of the trench can be greater than the thickness of the dielectric layer on the side walls so as to improve the withstand voltage capability of the bottom of the gate dielectric layer 407.

Gate 408 is polysilicon gate of the first conductive type, which is arranged within the gate trench, and has an ion doping concentration of greater than 1E18 cm⁻³.

A shielding region 406 is a doped region of the second conductive type. The shielding regions 406 are located within the drift layer 402 and are arranged under the gate trench at intervals in the longitudinal direction (Y direction). The top of the shielding region 406 is in contact with the bottom of a gate trench and the bottom of well regions 403. An ion doping concentration of the shielding region 406 is greater than 1E15 cm⁻³, and a junction depth (depth) of the shielding region 406 is 0.2 to 5 µm_{∘}

In this embodiment, the shielding regions 406 under two adjacent gate trenches are arranged to be aligned with each other or to be staggered from each other (not shown in the figure).

The shielding region 406 can greatly reduce an electric field stress of the gate dielectric layer 407 of a device in a blocking state, thereby greatly improving the long-term use reliability of the device.

Further, since that the top of the shielding region 406 is in contact with the bottom of the gate trench and the bottom of the well regions 403 and that the first source regions 404 and the second source regions 405 in the surface of the well regions 403 are electrically connected with the source metal layer 410, the shielding region 406 is in electrical connection (short-circuited connection) with the source metal layer 410 through the well regions 403 and the second source regions 405 such that a switching frequency of the device can be improved and switching loss can be reduced.

Since the shielding regions 406 are arranged at the bottom of the gate trench at intervals in the longitudinal direction and are in short-circuited connection with the source metal layer 410, at a portion of a trench gate (including the gate trench, a gate dielectric layer 407 and gate 408) where a shielding region 406 is involved, no channel is formed on either side of the trench gate, and thus there will be no channel current (conduction current) generated, but at a portion of the trench gate where no shielding region 406 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 407 in the blocking state. Further, the formation process of the shielding regions 406 affects neither an ion doping concentration in the electrical conduction region (on the surface of the trench) nor the electrical characteristics of the device such as a threshold voltage and the like, thereby facilitating current equalization among cells.

Also, since the top of the shielding region 406 is in contact with the bottom of the gate trench and the bottom of the well regions 403, a problem of process difficulty in the prior art caused by the fact that the shielding region is not allowed to contact the well regions and a certain etching depth is required for the gate trench can be overcome.

A storage region 412 is a doped region of the first conductive type. The storage region 412 is also located under a gate trench. The storage regions 412 are arranged to be alternated in relation to the shielding regions 406 in the longitudinal direction (Y direction), and the storage regions 412 are not in contact with the shielding regions 406. The top of the storage region 412 is in contact with the bottom of a gate trench and the bottom of well regions 403. An ion doping concentration of the storage region 412 is greater than an ion doping concentration of the substrate 201.

The storage region 412 can enhance the current conduction capacity of the electrical conduction region. Based on the presence of the storage region 412, a size of the conduction region can be further reduced, that is, a longitudinal distance between the shielding regions 406 can be further reduced without affecting the current conduction capacity of the conduction region.

An interlayer dielectric layer 409 is located above the gate 408, and the interlayer dielectric layer 409 isolates the gate 408 from the source metal layer 410.

The source metal layer 410 is located above the source regions (including the first source regions 404 and the second source regions 405), and is electrically connected with both the first source regions 404 and the second source regions 405. The source metal layer 410 may be made of a metal such as aluminum, nickel and the like which has a low contact resistivity with SiC.

The drain metal layer 411 is located under the substrate 401 and forms an ohmic contact with the substrate 401. Metal of drain may be a metal such as aluminum, nickel and the like which has a low contact resistivity with SiC.

It should be noted that, the silicon carbide device in this embodiment is a trench gate silicon carbide MOSFET device.

Correspondingly, the first conductive type is opposite to the second conductive type. For example, in the case that the first conductive type is N type, the second conductive type is P type; and in the case that the first conductive type is P type, the second conductive type is N type.

This embodiment provides a cellular structure 400 of silicon carbide device, in which, by forming the shielding regions 406 of the second conductive type which are arranged at intervals in the longitudinal direction at the bottom of the gate trench, it is possible to greatly reduce the electric field stress of the gate dielectric layer 407 of the device in a blocking state, and thus greatly improve the long-term use reliability of the device; by contacting the shielding region 406 with the bottom of the well regions 403, the shielding region 406 can be electrically connected with the source metal layer 410 through the well regions 403 and the source regions, such that the switching frequency of the device is improved and the switching loss is reduced; and by providing the shielding regions 406 which are arranged at intervals in the longitudinal direction, it is possible to separate the electrical conduction region from the electric field protection region, and the formation process of the shielding regions 406 affects neither the ion doping concentration in the electrical conduction region nor the electrical characteristics of the device such as a threshold voltage and the like, thereby facilitating current equalization among cells.

### Embodiment 4

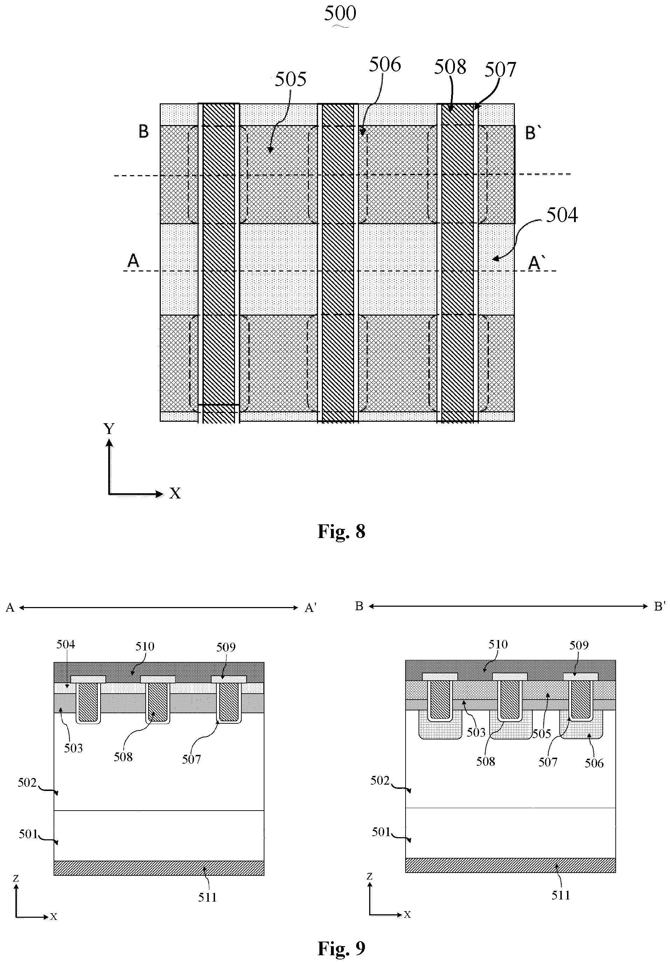

As shown in Figs. 8 and 9, an embodiment of the present disclosure provides a cellular structure 500 of silicon carbide device, comprising a substrate 501, a drift layer 502, well regions 503, source regions (not denoted in the figure), shielding regions 506, gate trenches (not denoted in the figure), gate dielectric layers 507, gates 508, interlayer dielectric layers 509, a source metal layer 510 and a drain metal layer 511.

It should be noted that, in this embodiment, in the following, the term "transverse direction" refers to "X direction", the term "longitudinal direction" refers to "Y direction", the term "width" refers to "a width in X direction", and the term "depth" refers to "a depth in Z direction".

It should be noted that, in order to clearly show the shapes and positions of the source regions (not denoted in the figure), the shielding regions 506, the gate trenches (not denoted in the figure), the gate dielectric layers 507 and the gates 508 in Fig. 8, the substrate 501, the drift layer 502, the well regions 503, the interlayer dielectric layers 509, the source metal layer 510 and the drain metal layer 511 are not shown in Fig. 8. Instead, the shapes and positions of the substrate 501, the drift layer 502, the well regions 503, the interlayer dielectric layers 509, the source metal layer 510 and the drain metal layer 511 may be comprehended in conjunction with Fig. 9.

By way of example, the substrate 501 is a silicon carbide substrate 501 of a first conductive type. The substrate 501 has a relatively large thickness and a relatively high ion doping concentration, with an ion doping concentration of greater than 1E18 cm⁻³.

The drift layer 502 is a drift layer 502 of the first conductive type, which is located above the substrate 501. The drift layer 502 has an ion doping concentration of about 1E14 to 5E16 cm⁻³. The ion doping concentration and a thickness of the drift layer 502 need to be optimized according to a withstand voltage of a chip.

A well region 503 is a well region 503 of a second conductive type. A plurality of well regions 503 are arranged in the surface of the drift layer 502 at intervals. The upper surface of the well region 503 is flush with the upper surface of the drift layer 502. The well region 503 has an ion doping concentration of 1E16 to 1E18 cm⁻³ and a depth of 0.3 to 1.5 µm_{∘}

A source region is located in the surface of the well region 503. In this embodiment, the source region includes first source regions 504 and second source regions 505. The first source regions 504 and the second source regions 505 are arranged to be alternated with each other in the longitudinal direction (Y direction).

A first source region 504 is a source region of the first conductive type. The upper surface of the first source region 504 is flush with the upper surface of the well region 503. The first source region 504 has its both ends in contact with side walls of gate trenches at both sides of the first source region. A width of the first source region 504 is equal to a width of the well region 503, and a depth of the first source region 504 is less than the depth of the well region 503. The first source region 504 has an ion doping concentration of greater than 1E19 cm⁻³ and a depth of 0.2 to 0.5 µm_{∘}

A second source region 505 is a source region of the second conductive type. The upper surface of the second source region 505 is flush with the upper surface of the well region 503. The second source region 505 has its both ends in contact with side walls of gate trenches at both sides of the second source region. A width of the second source region 505 is equal to the width of the first source region 504. A depth of the second source region 505 is greater than the depth of the first source region 504, but is less than the depth of the well region 503. An ion doping concentration of the second source region 505 is greater than the ion doping concentration of the well region 503. The second source region 505 has an ion doping concentration of greater than 5E18 cm⁻³ and a depth of 0.3 to 1.5 µm_{∘}

In this embodiment, the silicon carbide device is a silicon carbide device with a body diode enhanced structure. The body diode thereof (not shown in the figure) has a high conduction current, thereby achieving a good device performance.

A gate trench (not denoted in the figure) is located between two adjacent well regions 503, and a side wall of the gate trench is in contact with both a well region 503 and a first source region 504 in a source region. A depth of the gate trench is greater than the depth of the well region 503. The depth of the gate trench is 0.4 to 2.0 µm, and a width of the gate trench is 0.15 to 3.0 µm_{∘}

A gate dielectric layer 507 is uniformly arranged on side walls and the bottom of the gate trench. The gate dielectric layer 507 is an oxidation layer with a thickness of about 30 nm to 1000 nm. The thickness of the dielectric layer at the bottom of the trench can be greater than the thickness of the dielectric layer on the side walls so as to improve the withstand voltage capability of the bottom of the gate dielectric layer 507.

Gate 508 is polysilicon gate of the first conductive type, which is arranged within the gate trench, and has an ion doping concentration of greater than 1E18 cm⁻³.

A shielding region 506 is a doped region of the second conductive type. The shielding regions 506 are located within the drift layer 502 and are arranged under the gate trench at intervals in the longitudinal direction (Y direction). The top of the shielding region 506 is in contact with the bottom of a gate trench and the bottom of well regions 503. An ion doping concentration of the shielding region 506 is greater than 1E15 cm⁻³, and a junction depth (the depth) of the shielding region 506 is 0.2 to 5 µm_{∘}

In this embodiment, the shielding regions 506 under two adjacent gate trenches are arranged to be aligned with each other, and the shielding regions 506 are arranged to be aligned with the second source regions 505 in a transverse direction (X direction).

The shielding regions 506 can greatly reduce an electric field stress of the gate dielectric layer 507 of a device in a blocking state, thereby greatly improving the long-term use reliability of the device.

Further, since that the top of the shielding region 506 is in contact with the bottom of the gate trench and the bottom of the well regions 503 and that the first source regions 504 and the second source regions 505 in the surface of the well regions 503 are electrically connected with the source metal layer 510, the shielding region 506 is in electrical connection (short-circuited connection) with the source metal layer 510 through the well regions 503 and the second source regions 505, such that a switching frequency of the device can be improved and switching loss may be reduced.

Since the shielding regions 506 are arranged at the bottom of the gate trench at intervals in the longitudinal direction and are in short-circuited connection with the source metal layer 510, at a portion of a trench gate (including the gate trench, a gate dielectric layer 507 and gate 508) where a shielding region 506 is involved, no channel is formed on either side of the trench gate, and thus there is no channel current (conduction current) generated, but at a portion of the trench gate where no shielding region 506 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 507 in the blocking state. Further, the formation process of the shielding regions 506 affects neither the ion doping concentration in the electrical conduction region (on the surface of the trench) nor the electrical characteristics of the device such as a threshold voltage and the like, thereby facilitating current equalization among cells.

Also, since the top of the shielding region 506 is in contact with the bottom of the gate trench and the bottom of the well regions 503, a problem of process difficulty in the prior art caused by the fact that the shielding region is not allowed to contact the well regions and a certain etching depth is required for the gate trench can be overcome.

An interlayer dielectric layer 509 is located above the gate 508, and the interlayer dielectric layer 509 separates the gate 508 from the source metal layer 510.

The source metal layer 510 is located above the source regions (including the first source regions 504 and the second source regions 505), and is electrically connected with both the first source regions 504 and the second source regions 505. The source metal layer 510 may be made of a metal such as aluminum, nickel and the like which has a low contact resistivity with SiC.

The drain metal layer 511 is located under the substrate 501 and forms an ohmic contact with the substrate 501. Metal of drain may be a metal such as aluminum, nickel and the like which has a low contact resistivity with SiC.

It should be noted that, the silicon carbide device in this embodiment is a trench gate silicon carbide MOSFET device.

Correspondingly, the first conductive type is opposite to the second conductive type. For example, in the case that the first conductive type is N type, the second conductive type is P type; and in the case that the first conductive type is P type, the second conductive type is N type.

This embodiment provides a cellular structure 500 of silicon carbide device, in which, by forming the shielding regions 506 of the second conductive type which are arranged at intervals in the longitudinal direction at the bottom of the gate trench, it is possible to greatly reduce the electric field stress of the gate dielectric layer 507 of the device in a blocking state, and thus greatly improve the long-term use reliability of the device; by contacting the shielding region 506 with the bottom of the well regions 503, the shielding region 506 can be electrically connected with the source metal layer 510 through the well regions 503 and the source regions, such that the switching frequency of the device is improved and the switching loss is reduced; and by providing the shielding regions 506, which are arranged at intervals in the longitudinal direction, it is possible to separate the electrical conduction region from the electric field protection region, and the formation process of the shielding regions 506 affects neither the ion doping concentration in the electrical conduction region nor the electrical characteristics of the device such as a threshold voltage and the like, thereby facilitating current equalization among cells.

### Embodiment 5

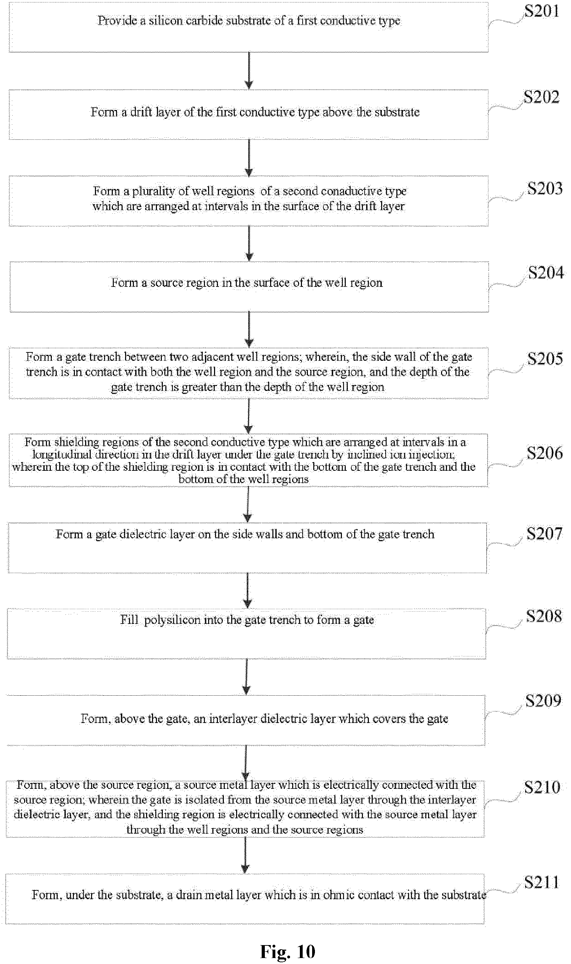

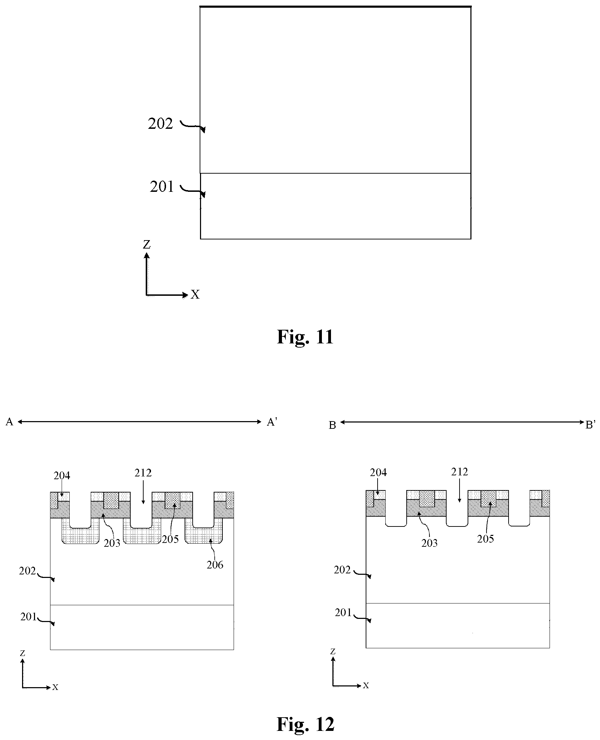

On the basis of Embodiment 1, the present embodiment provides a method for preparing the cellular structure 200 of silicon carbide device. Fig. 10 is a schematic flow diagram of the method for preparing the cellular structure 200 of silicon carbide device as shown in an embodiment of the present disclosure. Figs. 11-15 are schematic diagrams of cross-sectional structures formed by related steps of the method for preparing the cellular structure 200 of silicon carbide device shown in an embodiment of the present disclosure. Hereafter, the detailed steps of an exemplary method for preparing the cellular structure 200 of silicon carbide device provided by an embodiment of the present disclosure will be described with reference to Fig. 10 and Figs. 11 to 15.

As shown in Fig. 10, the method for preparing the cellular structure 200 of silicon carbide device in this embodiment comprises the following steps S201 to S211.

At step S201, a silicon carbide substrate 201 of a first conductive type is provided.

The substrate 201 has a relatively large thickness and a relatively high ion doping concentration, with an ion doping concentration of greater than 1E18 cm⁻³.

At step S202, as shown in Fig. 11, a drift layer 202 of the first conductive type is formed above the substrate 201.

Specifically, the drift layer 202 is a uniformly doped silicon carbide layer, and has an ion doping concentration of about 1E14 to 5E16 cm⁻³. The ion doping concentration and a thickness of the drift layer 202 need to be optimized according to a withstand voltage of a chip .

At step S203, a plurality of well regions 203 of a second conductive type which are arranged at intervals are formed in the surface of the drift layer 202.

Specifically, ions of the second conductive type are injected into the surface of the drift layer 202 to form the plurality of well regions 203 of the second conductive type which are arranged at intervals. The upper surface of a well region 203 is flush with the upper surface of the drift layer 202. The well region 203 has an ion doping concentration of 1E16 to 1E18 cm⁻³ and a depth of 0.3 to 1.5 µm_{∘}

At step S204, a source region is formed in the surface of a well region 203.

In this embodiment, the source region includes a first source region 204 and second source regions 205.

The step S204 specifically comprises the following steps:
A first source region 204 of the first conductive type is formed in the surface of the well region 203, wherein the first source region 204 has its both ends in contact with side walls of gate trenches at both sides of the first source region, respectively;
Second source regions 205 of the second conductive type which are arranged at intervals in the longitudinal direction are formed in the first source region 204, wherein a second source region 205 is not in contact with the side walls of the gate trenches.

Specifically, ions of the first conductive type are injected into the well region 203 by ion implantation to form the first source region 204 of the first conductive type in the well region 203; a part of the surface of the first source region 204 is selectively shielded by photoresist by using photolithography process; and then ions of the second conductive type are injected into the first source region 204 by ion implantation to form the second source regions 205 of the second conductive type in the first source region 204.

The first source region 204 is a source region of the first conductive type. The first source region 204 is located in the surface of the well region 203. The upper surface of the first source region 204 is flush with the upper surface of the well region 203. The first source region 204 has its both ends in contact with the side walls of the gate trenches at both sides of the first source region. A width of the first source region 204 is equal to the width of the well region 203, and a depth of the first source region 204 is less than the depth of the well region 203. The first source region 204 has an ion doping concentration of greater than 1E19 cm⁻³ and a depth of 0.2 to 0.5 µm_{∘}

A second source region 205 is a source region of the second conductive type. The second source regions 205 are arranged in the first source regions 204 at intervals in the longitudinal direction (Y direction). The upper surface of the second source region 205 is flush with the upper surface of the well region 203. The second source region 205 is not in contact with the side walls of the gate trenches. A width of the second source region 205 is less than the width of the first source region 204. A depth of the second source region 205 is greater than the depth of the first source region 204, but is less than the depth of the well region 203. An ion doping concentration of the second source region 205 is greater than the ion doping concentration of the well region 203. The second source region 205 has an ion doping concentration of greater than 5E18 cm⁻³ and a depth of 0.3 to 1.5 µm_{∘}

At step S205, a gate trench is formed between two adjacent well regions 203, wherein a side wall of the gate trench is in contact with both a well region 203 and a source region, and a depth of the gate trench is greater than the depth of the well region.

Specifically, a region between two adjacent well regions 203 is etched off to form the gate trench between the two adjacent well regions 203, wherein a side wall of the gate trench is in contact with both a well region 203 and a first source region 204 in a the source region. A depth of the gate trench is greater than the depth of the well region 203. The depth of the gate trench is 0.4 to 2.0 µm, and a width of the gate trench is 0.15 to 3.0 µm_{∘}

It should be noted that, the above steps for forming the well region 203, the first source region 204, the second source region 205 and the gate trench may also implemented as follows: forming an intact well region 203 on the entire surface → forming the first source regions 204 and the second source regions 205 → etching to form the gate trenches.

At step S206, as shown in Fig. 12, shielding regions 206 of the second conductive type which are arranged at intervals in the longitudinal direction (Y direction) are formed within the drift layer 202 and under the gate trench by inclined ion implantation, wherein the top of a shielding region 206 is in contact with both the bottom of a gate trench and the bottom of well regions 203.

By using photolithography process, parts of the upper surface of the source regions (including the first source regions 204 and the second source regions 205) as well as partial bottom and side walls of respective gate trenches are selectively shielded by photoresist. Next, by title ion implanting, ions of the second conductive type not only can be injected into the drift layer 202 at the bottom of the trenches, but also into the drift layer 202 beside the side walls of each trench, which are near the bottom of the trench and are not covered by photoresist. Then, by high temperature annealing process with impurity activation, the shielding regions of the second conductive type which are arranged at intervals in the longitudinal direction can be readily formed under the gate trench. The top of each shielding region 206 is in contact with the bottom of the gate trench and the bottom of the well regions 203.

In this embodiment, the shielding regions 206 under two adjacent gate trenches are arranged to be aligned with each other.

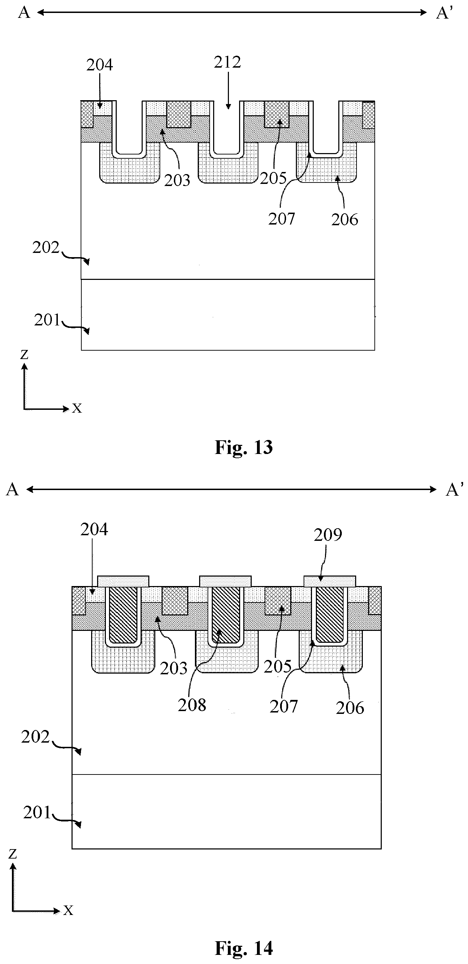

At step S207, as shown in Fig. 13, a gate dielectric layer 207 is formed on side walls and the bottom of a gate trench.

Specifically, the step S207 comprises the following steps:
At S207a, a sacrificial oxidation treatment is performed on the surface of the drift layer 202 as well as the side walls and the bottom of the gate trench;
At S207b, a gate dielectric layer 207 is formed above the drift layer 202 as well as the side walls and the bottom of the gate trench; and
At S207c, the gate dielectric layer 207 above the drift layer 202 is etched off.

The sacrificial oxidation treatment comprises the following steps:
(a) The surface of the drift layer 202 is subjected to thermal oxidization to form a sacrificial oxidation layer (not shown in the figure), wherein a thickness of the sacrificial oxidation layer is 10 to 20 nm; and
(b) The sacrificial oxidation layer is removed by wet etching.

The gate dielectric layer 207 is an oxidation layer, which, similar to the sacrificial oxidation layer, is also formed by thermal oxidization in an oxygen atmosphere at a high temperature (e.g. 1300 °C). A thickness of the gate dielectric layer 207 is about 30 nm to 1000 nm. The thickness of the dielectric layer at the bottom of the trench can be greater than the thickness of the dielectric layer on the side walls so as to improve the withstand voltage capability of the bottom of the gate dielectric layer 207.

The shielding region 206 can greatly reduce an electric field stress of the gate dielectric layer 207 of a device in a blocking state, thereby greatly improving the long-term use reliability of the device.

At step S208, polysilicon is filled into a gate trench to form gate 208.

In this case, the polysilicon filled is high doping concentration polysilicon of the first conductive type, and has an ion doping concentration of greater than 1E18 cm⁻³.

At step S209, as shown in Fig. 14, an interlayer dielectric layer 209 covering gate 208 is formed above the gate 208.

Specifically, an intact interlayer dielectric layer 209 is firstly formed above the entire surface of the drift layer 202, and then etching is performed thereon so that only interlayer dielectric layers 209 right above gates 208 are remained.

At step S210, a source metal layer 210 which is electrically connected with the source regions is formed above the source regions, wherein each gate 208 is isolated from the source metal layer 210 through the interlayer dielectric layer 209, and each shielding region 206 is electrically connected with the source metal layer 210 through the well regions 203 and the source regions.

The source metal layer 210 which is electrically connected with both the first source regions 204 and the second source regions 205 is formed above the first source regions 204 and the second source regions 205 by metallization process.

Since that the top of the shielding region 206 is in contact with the bottom of the gate trench and the bottom of the well regions 203 and that the first source regions 204 and the second source regions 205 in the surface of the well regions 203 are electrically connected with the source metal layer 210, the shielding region 206 is in electrical connection (short-circuited connection) with the source metal layer 210 through the well regions 203 and the second source regions 205, such that the switching frequency of the device can be improved and the switching loss can be reduced.

Since the shielding regions 206 are arranged at the bottom of the gate trench at intervals in the longitudinal direction and are in short-circuited connection with the source metal layer 210, at a portion of a trench gate (including the gate trench, a gate dielectric layer 207, and gate 208) where a shielding region 206 is involved, no channel is formed on either side of the trench gate, and thus there is no channel current (conduction current) generated, but at a portion of the trench gate where no shielding region 206 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 207 in the blocking state. Further, the formation process of the shielding regions 206 affects neither an ion doping concentration in the electrical conduction region (on the surface of the trench) nor the electrical characteristics of the device such as a threshold voltage and the like, thereby facilitating current equalization among cells.

Also, since the top of the shielding region 206 is in contact with the bottom of the gate trench and the bottom of the well regions 203, a problem of process difficulty in the prior art caused by the fact that the shielding region is not allowed to contact the well regions and a certain etching depth is required for the gate trench can be overcome.

The source metal layer 210 may be made of a metal such as aluminum, nickel and the like which has a low contact resistivity with SiC.

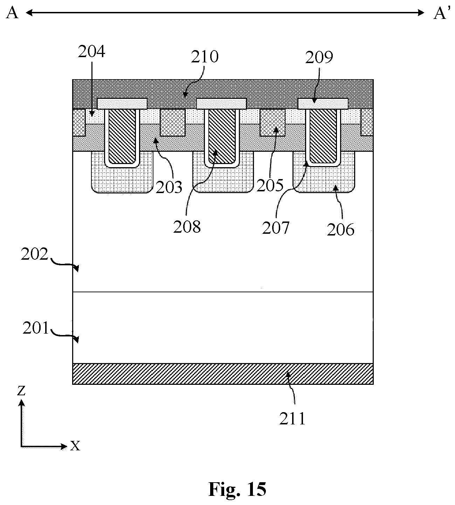

At S211, as shown in Fig. 15, a drain metal layer 211 which is in ohmic contact with the substrate 201 is formed under the substrate 201.

Specifically, the drain metal layer 211 which is in ohmic contact with the substrate 201 is formed under the substrate 201 by metallization process. The drain metal layer 211 may be made of a metal such as aluminum, nickel and the like which has a low contact resistivity with SiC.

The whole preparation process has a simple manufacturing process, a high manufacturability and a low manufacturing cost.

Correspondingly, the first conductive type is opposite to the second conductive type. For example, in the case that the first conductive type is N type, the second conductive type is P type; and in the case that the first conductive type is P type, the second conductive type is N type.

This embodiment provides a method for preparing the cellular structure 200 of silicon carbide device, in which by forming the shielding regions 206 of the second conductive type which are arranged at intervals in the longitudinal direction at the bottom of the gate trench, it is possible to greatly reduce the electric field stress of the gate dielectric layer 207 of the device in a blocking state, and thus greatly improve the long-term use reliability of the device; by contacting the shielding region 206 with the bottom of the well regions 203, the shielding region 206 can be electrically connected with the source metal layer 210 through the well regions 203 and the source regions, such that the switching frequency of the device is improved and the switching loss is reduced; and by providing the shielding regions 206 which are arranged at intervals in the longitudinal direction, it is possible to separate the electrical conduction region from the electric field protection region, and the formation process of the shielding regions 206 affects neither the ion doping concentration in the electrical conduction region nor the electrical characteristics of the device such as a threshold voltage and the like, thereby facilitating current equalization among cells. Furthermore, the preparation process has a simple manufacturing process, a high manufacturability and a low manufacturing cost.

### Embodiment 6

On the basis of Embodiment 2, the present embodiment provides a method for preparing the cellular structure 300 of silicon carbide device.

The method for preparing the cellular structure 300 of silicon carbide device is similar to the method for preparing the cellular structure 200 of silicon carbide device in Embodiment 5, except an arrangement of the positions of the shielding regions 306, so it will not be described any further here.

### Embodiment 7

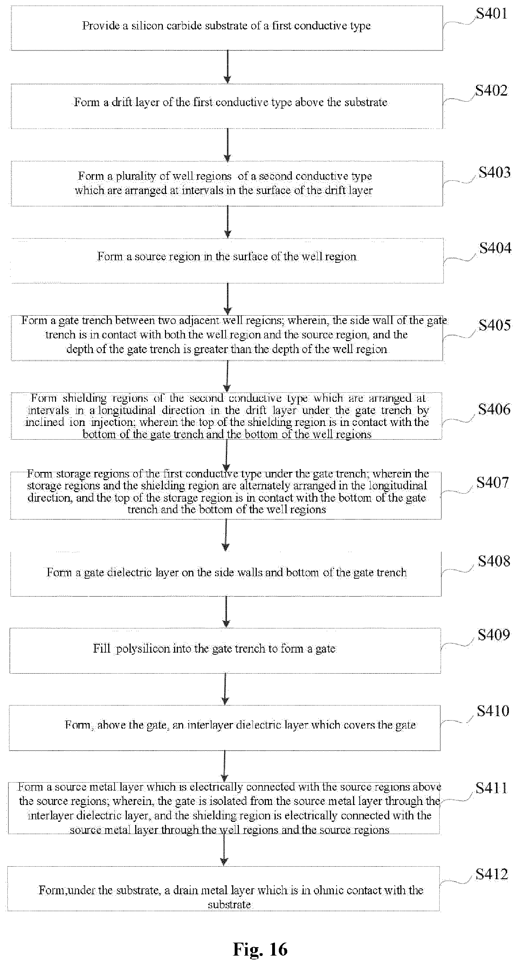

On the basis of Embodiment 3, the present embodiment provides a method for preparing the cellular structure 400 of silicon carbide device. Fig. 16 is a schematic flow diagram of the method for preparing the cellular structure 400 of silicon carbide device shown in an embodiment of the present disclosure.

As shown in Fig. 16, the method for preparing the cellular structure 400 of silicon carbide device in this embodiment comprises the following steps S401 to S412.

At step S401, a silicon carbide substrate 401 of a first conductive type is provided.

The substrate 401 has a relatively large thickness and a relatively high ion doping concentration, with an ion doping concentration of greater than 1E18 cm⁻³.

At step S402, a drift layer 402 of the first conductive type is formed above the substrate 401.

Specifically, the drift layer 402 is a uniformly doped silicon carbide layer, and has an ion doping concentration of about 1E14 to 5E16 cm⁻³. The ion doping concentration and a thickness of the drift layer 402 need to be optimized according to a withstand voltage of a chip.

At step S403, a plurality of well regions 403 of a second conductive type which are arranged at intervals are formed in the surface of the drift layer 402.

Specifically, ions of the second conductive type are injected into the surface of the drift layer 402 to form the plurality of well regions 403 of the second conductive type which are arranged at intervals. The upper surface of a well region 403 is flush with the upper surface of the drift layer 402. The well region 403 has an ion doping concentration of 1E16 to 1E18 cm⁻³ and a depth of 0.3 to 1.5 µm.

At step S404, a source region is formed in the surface of a well region 403.

In this embodiment, the source region includes a first source region 404 of the first conductive type and second source regions 405 which are arranged in the first source region at intervals in the longitudinal direction 404.

The step S404 specifically comprises the following steps:
A first source region 404 of the first conductive type is formed in the surface of a well region 403, wherein the first source region 404 has its both ends in contact with side walls of gate trenches at both sides of the first source region, respectively;
Second source regions 405 of the second conductive type which are arranged at intervals in the longitudinal direction are formed in the first source region 404, wherein a second source region 405 is not in contact with the side walls of the gate trenches.

Specifically, ions of the first conductive type are injected into the well region 403 by ion implantation to form the first source region 404 of the first conductive type in the well region 403; a part of the surface of the first source region 404 is selectively shielded by photoresist by using photolithography process; and then ions of the second conductive type are injected into the first source region 404 by ion implantation to form the second source regions 405 of the second conductive type in the first source region 404.

The first source region 404 is a source region of the first conductive type. The first source region 404 is located in the surface of the well region 403. The upper surface of the first source region 404 is flush with the upper surface of the well region 403. The first source region 404 has its both ends in contact with side walls of gate trenches at both sides of the first source region. A width of the first source region 404 is equal to the width of the well region 403, and a depth of the first source region 404 is less than the depth of the well region 403. The first source region 404 has an ion doping concentration of greater than 1E19 cm⁻³ and a depth of 0.2 to 0.5 µm_{∘}

A second source region 405 is a source region of the second conductive type. The second source regions 405 are arranged in the first source region 404 at intervals in the longitudinal direction (Y direction). The upper surface of the second source region 405 is flush with the upper surface of the well region 403. The second source region 405 is not in contact with the side walls of the gate trenches. A width of the second source region 405 is less than the width of the first source region 404. A depth of the second source region 405 is greater than the depth of the first source region 404, but is less than the depth of the well region 403. An ion doping concentration of the second source region 405 is greater than the ion doping concentration of the well region 403. The second source region 405 has an ion doping concentration of greater than 5E18 cm⁻³, and a depth of 0.3 to 1.5 µm_{∘}

At step S405, a gate trench is formed between two adjacent well regions 403; wherein a side wall of the gate trench is in contact with both a well region 403 and a source region, and a depth of the gate trench is greater than the depth of the well region.

Specifically, a region between two adjacent well regions 403 is etched off to form the gate trench between the two adjacent well regions 403, wherein a side wall of the gate trench is in contact with both a well region 403 and a first source region 404 in a source region. A depth of the gate trench is greater than the depth of the well region 403. The depth of the gate trench is 0.4 to 2.0 µm, and a width of the gate trench is 0.15 to 3.0 µm_{∘}

It should be noted that, the above steps for forming the well region 403, the first source region 404, the second source region 405 and the gate trench may also be implemented as follows: forming an intact well region 403 on the entire surface→ forming the first source regions 404 and the second source regions 405 → etching to form the gate trenches.

At step S406, shielding regions 406 of the second conductive type which are arranged at intervals in the longitudinal direction (Y direction) are formed in the drift layer 402 under the gate trench by inclined ion implantation; wherein the top of a shielding region 406 is in contact with both the bottom of a gate trench and the bottom of well regions 403.

By using photolithography process, parts of the upper surface of the source regions (including the first source regions 404 and the second source regions 405) as well as partial bottom and side walls of respective gate trenches are selectively shielded by photoresist. Next, by title ion implanting, ions not only can be injected into the drift layer 402 at the bottom of the trenches, but also into the drift layer 402 beside the side walls of each trench, which are near the bottom of the trench and are not covered by photoresist. Then, by high temperature annealing process with impurity activation, the shielding regions 406 of the second conductive type which are arranged at intervals in the longitudinal direction can be readily formed under the gate trench. The top of each shielding region 406 is in contact with the bottom of the gate trench and the bottom of the well regions 403.

In this embodiment, the shielding regions 406 under two adjacent gate trenches are arranged to be aligned with each other or staggered from each other.

At S407, a storage region 412 of the first conductive type are formed under a gate trench; wherein, storage regions 412 are arranged to be alternated in relation to the shielding regions 406 in the longitudinal direction, and the top of the storage region 412 is in contact with the bottom of a gate trench and the bottom of well regions 403.

By using photolithography process, parts of the upper surface of the source regions (including the first source regions 404 and the second source regions 405) and the shielding regions 406 are selectively shielded by photoresist. Next, by title ion implanting, ions of the first conductive type not only can be injected into the drift layer 402 at the bottom of the trenches, but also into the drift layer 402 beside the side walls of each trench, which are near the bottom of the trench and are not covered by photoresist. Then, by high temperature annealing process with impurity activation, the storage regions 412 of the first conductive type can be readily formed under the gate trench. The storage regions 412 are arranged to be alternated in relation to the shielding regions 406 in the longitudinal direction, and the storage regions 412 are not in contact with the shielding regions 406. The top of each storage region 412 is in contact with the bottom of a gate trench and the bottom of the well regions 403.

The storage region 412 can enhance the current conduction capacity of the electrical conduction region. Based on the presence of the storage region 412, a size of the conduction region can be further reduced, that is, a longitudinal distance between the shielding regions 406 can be further reduced without affecting the current conduction capacity of the conduction region.

At step S408, a gate dielectric layer 407 is formed on side walls and the bottom of a gate trench.

Specifically, the step S408 comprises the following steps:
At S408a, a sacrificial oxidation treatment is performed on the surface of the drift layer 402 as well as the side walls and the bottoms of the gate trenches;
At S408b, a gate dielectric layer 407 is formed above the drift layer 402 as well as on the side walls and the bottom of each of the gate trench; and
At S408c, the gate dielectric layer 407 above the drift layer 402 is etched off.

The sacrificial oxidation treatment comprises the following steps:
(a) The surface of the drift layer 402 is subjected to thermal oxidization to form a sacrificial oxidation layer (not shown in the figure); wherein a thickness of the sacrificial oxidation layer is 10 to 40 nm; and
(b) The sacrificial oxidation layer is removed by wet etching.
the gate dielectric layer 407 is an oxidation layer, which, similar to the sacrificial oxidation layer, is also formed by thermal oxidization in an oxygen atmosphere at a high temperature (e.g. 1300 °C). A thickness of the gate dielectric layer 407 is about 30 nm to 1000 nm. The thickness of the dielectric layer at the bottom of the trench can be greater than the thickness of the dielectric layer on the side walls so as to improve the withstand voltage capability of the bottom of the gate dielectric layer 407.

The shielding region 406 can greatly reduce an electric field stress of the gate dielectric layer 407 of the device in a blocking state, thereby greatly improving the long-term use reliability of the device.

At step S409, polysilicon is filled into the gate trenches to form gates 408.

In this case, the polysilicon filled is high doping concentration polysilicon of the first conductive type, and has an ion doping concentration of greater than 1E18 cm⁻³.

At step S410, interlayer dielectric layers 409 covering the gates 408 are formed above the gates 408.

Specifically, an intact interlayer dielectric layer 409 is firstly formed above the entire surface of the drift layer 402, and then etching is performed thereon so that only interlayer dielectric layers 409 right above the gates 408 are remained.

At step S411, a source metal layer 410 which is electrically connected with the source regions is formed above the source regions; wherein the gates 408 are isolated from the source metal layer 410 through the interlayer dielectric layers 409, and each of the shielding regions 406 is electrically connected with the source metal layer 410 through the well regions 403 and the source regions.

The source metal layer 410 which is electrically connected with both the first source regions 404 and the second source regions 405 is formed above the first source regions 404 and the second source regions 405 by metallization process.

Since that the top of a shielding region 406 is in contact with the bottom of a gate trench and the bottom of well regions 403 and that the first source regions 404 and the second source regions 405 in the surface of the well regions 403 are electrically connected with the source metal layer 410, the shielding region 406 is in electrical connection (short-circuited connection) with the source metal layer 410 through the well regions 403 and the second source regions 405, such that a switching frequency of the device can be improved and the switching loss can be reduced.

Since the shielding regions 406 are arranged at the bottom of the gate trench at intervals in the longitudinal direction and are in short-circuited connection with the source metal layer 410, at a portion of a trench gate (including the gate trench, a gate dielectric layer 407 and gate 408) where a shielding region 406 is involved, no channel is formed on either side of the trench gate, and thus there will be no channel current (conduction current) generated, but at a portion of the trench gate where no shielding region 406 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 407 in the blocking state. Further, the formation process of the shielding regions 406 affects neither an ion doping concentration in the electrical conduction region (on the surface of the trench) nor the electrical characteristics of the device such as a threshold voltage and the like, thereby facilitating current equalization among cells.

Also, since the top of the shielding region 406 is in contact with the bottom of the gate trench and the bottom of the well regions 403, a problem of process difficulty in the prior art caused by the fact that the shielding region is not allowed to contact the well regions and a certain etching depth is required for the gate trench can be overcome.

The source metal layer 410 may be made of a metal such as aluminum, nickel and the like which has a low contact resistivity with SiC.

At S412, a drain metal layer 411 which is in ohmic contact with the substrate 401 is formed under the substrate 401.

Specifically, the drain metal layer 411 which is in ohmic contact with the substrate 401 is formed under the substrate 401 by metallization process. The drain metal layer 411 may be made of a metal such as aluminum, nickel and the like which has a low contact resistivity with SiC.

The whole preparation process has a simple manufacturing process, a high manufacturability and a low manufacturing cost.

Correspondingly, the first conductive type is opposite to the second conductive type. For example, in the case that the first conductive type is N type, the second conductive type is P type; and in the case that the first conductive type is P type, the second conductive type is N type.

This embodiment provides a method for preparing the cellular structure 400 of silicon carbide device, in which by forming the shielding regions 406 of the second conductive type which are arranged at intervals in the longitudinal direction at the bottom of the gate trench, it is possible to greatly reduce the electric field stress of the gate dielectric layer 407 of the device in a blocking state, and thus greatly improve the long-term use reliability of the device; by contacting the shielding region 406 with the bottom of the well regions 403, the shielding region 406 can be electrically connected with the source metal layer 410 through the well regions 403 and the source regions, such that the switching frequency of the device is improved and the switching loss is reduced; and by providing the shielding regions 406 which are arranged at intervals in the longitudinal direction, it is possible to separate the electrical conduction region from the electric field protection region, and the formation process of the shielding regions 406 affects neither the ion doping concentration in the electrical conduction region nor the electrical characteristics of the device such as a threshold voltage and the like, thereby facilitating current equalization among cells. Furthermore, the preparation process has a simple manufacturing process, a high manufacturability and a low manufacturing cost.

### Embodiment 8

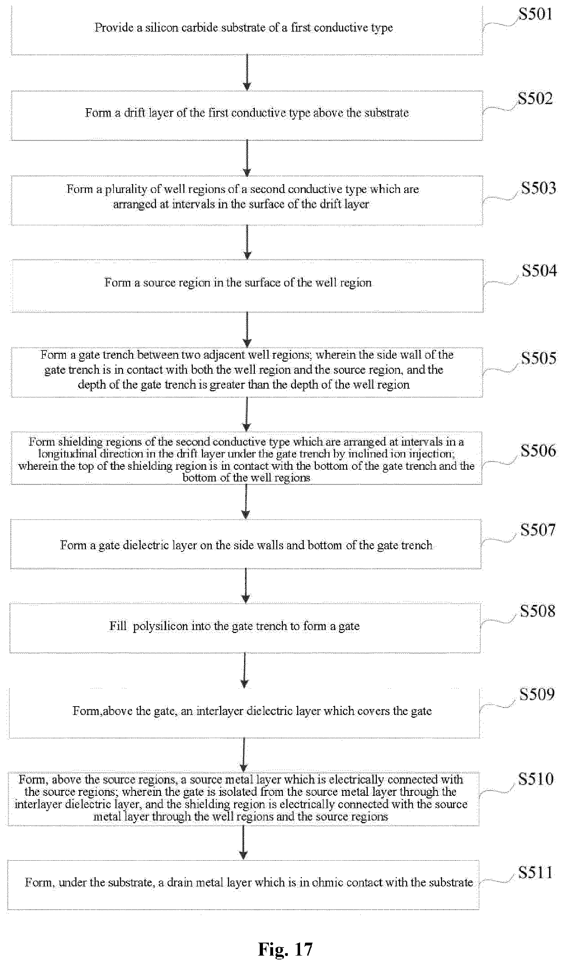

On the basis of Embodiment 4, the present embodiment provides a method for preparing the cellular structure 500 of silicon carbide device. Fig. 17 is a schematic flow diagram of the method for preparing the cellular structure 500 of silicon carbide device as shown in an embodiment of the present disclosure.

As shown in Fig. 17, the method for preparing the cellular structure 500 of silicon carbide device in this embodiment comprises the following steps S501 to S511.

At step S501, a silicon carbide substrate 501 of a first conductive type is provided.

The substrate 501 has a relatively large thickness and a relatively high ion doping concentration, with an ion doping concentration of greater than 1E18 cm⁻³.

At step S502, a drift layer 502 of the first conductive type is formed above the substrate 501.

Specifically, the drift layer 502 is a uniformly doped silicon carbide layer, and has an ion doping concentration of about 1E14 to 5E16 cm⁻³. The ion doping concentration and a thickness of the drift layer 502 need to be optimized according to a withstand voltage of a chip.

At step S503, a plurality of well regions 503 of a second conductive type which are arranged at intervals are formed in the surface of the drift layer 502.

Specifically, ions of the second conductive type are injected into the surface of the drift layer 502 to form the plurality of well regions 503 of the second conductive type which are arranged at intervals. The upper surface of a well region 503 is flush with the upper surface of the drift layer 502. The well region 503 has an ion doping concentration of 1E16 to 1E18 cm⁻³, and a depth of 0.3 to 1.5 µm_{∘}

At step S504, a source region is formed in the surface of the well region 503.

In this embodiment, the source region includes first source regions 504 and second source regions 505 which are arranged to be alternated with each other in the longitudinal direction.

Specifically, ions of the first conductive type and ions of the second conductive type are selectively injected into the well region 503 in sequence to form the first source regions 504 of the first conductive type and the second source regions 505 of the second conductive type, which two are arranged to be alternated with each other in the longitudinal direction in the surface of the well region 503.

A first source region 504 is a source region of the first conductive type. The upper surface of the first source region 504 is flush with the upper surface of the well region 503. The both ends of the first source region 504 are aligned with the both ends of the well region 503. A width of the first source region 504 is equal to a width of the well region 503, and a depth of the first source region 504 is less than a depth of the well region 503. The first source region 504 has an ion doping concentration of greater than 1E19 cm⁻³ and a depth of 0.2 to 0.5 µm

A second source region 505 is a source region of the second conductive type. The upper surface of the second source region 505 is flush with the upper surface of the well region 503. The both ends of the second source region 505 are aligned with the both ends of the well region 503. A width of the second source region 505 is equal to the width of the first source region 504. A depth of the second source region 505 is greater than the depth of the first source region 504, but is less than the depth of the well region 503. An ion doping concentration of the second source region 505 is greater than the ion doping concentration of the well region 503. The second source region 505 has an ion doping concentration of greater than 5E18 cm⁻³ and a depth of 0.3 to 1.5 µm.

In this embodiment, the silicon carbide device formed is a silicon carbide device with a body diode enhanced structure. The body diode thereof (not shown in the figure) has a high conduction current, thereby achieving a good device performance.

A gate trench is formed between two adjacent well regions 503; wherein a side wall of the gate trench is in contact with both a well region 503 and a source region, and a depth of the gate trench is greater than the depth of the well region.

Specifically, a region between two adjacent well regions 503 is etched off to form the gate trench between the two adjacent well regions 503, wherein a side wall of the gate trench is simultaneously in contact with a well region 503, first source regions 504 and second source regions 505. A depth of the gate trench is greater than the depth of the well region 503. The depth of the gate trench is 0.4 to 2.0 µm, and a width of the gate trench is 0.15 to 3.0 µm_{∘}

It should be noted that, the above steps for forming the well region 503, the first source region 504, the second source region 505 and the gate trench may also be implemented as follows: forming an intact well region 503 on the entire surface→ forming the first source regions 504 and the second source regions 505 → etching to form the gate trenches.

At step S506, shielding regions of the second conductive type 506 which are arranged at intervals in the longitudinal direction (Y direction) are formed within the drift layer 502 and under the gate trench by inclined ion implantation; wherein the top of a shielding region 506 is in contact with both the bottom of a gate trench and the bottom of well regions 503. The shielding regions 506 are arranged to be aligned with the second source regions 505 in the transverse direction.

By using photolithography process, parts of the upper surface of the source regions (including the first source regions 504 and the second source regions 505) and partial bottom and side walls of respective gate trenches are selectively shielded by photoresist. Next, by title ion implanting, ions of the second conductive type not only can be injected into the drift layer 502 at the bottom of the trenches, but also into the drift layer 502 beside the side walls of each trench, which are near the bottom of the trench and are not covered by photoresist. Then, by high temperature annealing process with impurity activation, the shielding regions of the second conductive type which are arranged at intervals in the longitudinal direction can be readily formed under the gate trench. The top of each shielding region 506 is in contact with the bottom of the gate trench and the bottom of the well regions 503.

In this embodiment, the shielding regions 506 under two adjacent gate trenches are arranged to be aligned with each other.

At step S507, a gate dielectric layer 507 is formed on side walls and the bottom of a gate trench.

Specifically, the step S507 comprises the following steps:
At S507a, a sacrificial oxidation treatment is performed on the surface of the drift layer 502 as well as the side walls and the bottom of the gate trench;
At S507b, a gate dielectric layer 507 is formed above the drift layer 502 as well as the side walls and the bottom of the gate trench; and
At S507c, the gate dielectric layer 507 above the drift layer 502 is etched off.

The sacrificial oxidation treatment comprises the following steps:
(a) The surface of the drift layer 502 is subjected to thermal oxidization to form a sacrificial oxidation layer (not shown in the figure); wherein a thickness of the sacrificial oxidation layer is 10 to 50 nm; and
(b) The sacrificial oxidation layer is removed by wet etching.

The gate dielectric layer 507 is an oxidation layer, which, similar to the sacrificial oxidation layer, is also formed by thermal oxidization in an oxygen atmosphere at a high temperature (e.g. 1300 ° 3). A thickness of the gate dielectric layer 507 is about 30 to 1000 nm. The thickness of the dielectric layer at the bottom of the trench can be greater than the thickness of the dielectric layer on the side wall so as to improve the withstand voltage capability of the bottom of the gate dielectric layer 507.

The shielding region 506 can greatly reduce an electric field stress of the gate dielectric layer 507 of the device in a blocking state, thereby greatly improving the long-term use reliability of the device.

At step S508, polysilicon is filled into the gate trenches to form gates 508.

In this case, the polysilicon filled is high concentration doped polysilicon of the first conductive type, and has an ion doping concentration of greater than 1E18 cm⁻³.

At step S509, interlayer dielectric layers 509 covering the gates 508 are formed above the gates 508.

Specifically, an intact interlayer dielectric layer 509 is firstly formed above the entire surface of the drift layer 502, and then etching is performed thereon so that only interlayer dielectric layers 509 right above the gates 508 are remained.

At step S510, a source metal layer 510 which is electrically connected with the source regions is formed above the source regions; wherein each gate 508 is isolated from the source metal layer 510 through the interlayer dielectric layer 509, and each shielding region 506 is electrically connected with the source metal layer 510 through the well regions 503 and the source regions.

The source metal layer 510 which is electrically connected with both the first source regions 504 and the second source regions 505 is formed above the first source regions 504 and the second source regions 505 by metallization process.

Since that the top of a shielding region 506 is in contact with the bottom of a gate trench and the bottom of the well regions 503 and that the first source regions 504 and the second source regions 505 in the surface of the well regions 503 are electrically connected with the source metal layer 510, the shielding region 506 is in electrical connection (short-circuited connection) with the source metal layer 510 through the well regions 503 and the second source regions 505, such that a switching frequency of the device can be improved and the switching loss can be reduced.

Since the shielding regions 506 are arranged at the bottom of the gate trench at intervals in the longitudinal direction and are in short-circuited connection with the source metal layer 510, at a portion of a trench gate (including the gate trench, a gate dielectric layer 507, and gate 508) where a shielding region 506 is involved, no channel is formed on either side of the trench gate, and thus there is no channel current (conduction current) generated, but at a portion of the trench gate where no shielding region 506 is involved, channels are formed on both sides of the trench gate such that a channel current (conduction current) is formed. That is, an electric field protection region and an electrical conduction region can be separated, which achieves a good compromise between ensuring the conduction current and effectively reducing the electric field stress of the gate dielectric layer 507 in the blocking state. Further, the formation process of the shielding regions 506 affects neither an ion doping concentration in the electrical conduction region (on the surface of the trench), nor the electrical characteristics of the device such as a threshold voltage and the like, thereby facilitating current equalization among cells.

Also, since the top of the shielding region 506 is in contact with the bottom of the gate trench and the bottom of the well regions 503, a problem of process difficulty in the prior art caused by the fact that the shielding region is not allowed to contact the well regions and a certain etching depth is required for the gate trench can be overcome.

The source metal layer 510 may be made of a metal such as aluminum, nickel and the like which has a low contact resistivity with SiC.

At S511, a drain metal layer 511 which is in ohmic contact with the substrate 501 is formed under the substrate 501.

Specifically, the drain metal layer 511 which is in ohmic contact with the substrate 501 is formed under the substrate 501 by metallization process. The drain metal layer 511 may be made of a metal such as aluminum, nickel and the like which has a low contact resistivity with SiC.

The whole preparation process has a simple manufacturing process, a high manufacturability and a low manufacturing cost.

Correspondingly, the first conductive type is opposite to the second conductive type. For example, in the case that the first conductive type is N type, the second conductive type is P type; and in the case that the first conductive type is P type, the second conductive type is N type.

This embodiment provides a method for preparing the cellular structure 500 of silicon carbide device, in which by forming the shielding regions 506 of the second conductive type which are arranged at intervals in the longitudinal direction at the bottom of the gate trench, it is possible to greatly reduce the electric field stress of the gate dielectric layer 507 of the device in a blocking state, and thus greatly improve the long-term use reliability of the device; by contacting the shielding region 506 with the bottom of the well regions 503, the shielding region 506 can be electrically connected with the source metal layer 510 through the well regions 503 and the source regions, such that the switching frequency of the device is improved and the switching loss is reduced; and by providing the shielding regions 506 which are arranged at intervals in the longitudinal direction, it is possible to separate the electrical conduction region from the electric field protection region, and the formation process of the shielding regions 506 affects the ion doping concentration in the electrical conduction region nor the electrical characteristics of the device such as a threshold voltage and the like, thereby facilitating current equalization among cells. Furthermore, the preparation process has a simple manufacturing process, a high manufacturability and a low manufacturing cost.

The above description only illustrates the preferred embodiments of the present disclosure, but is not intended to limit present the disclosure. For those skilled in the art, the present disclosure may involve various modifications and variations. Any of modifications, equivalent replacements, improvements, etc. that are made within the spirit and principles of the present disclosure should be included in the scope of protection of the present disclosure. Although the implementations of the present disclosure are disclosed as above, the contents thereof are only used to facilitate the understanding of the present disclosure, and are not intended to limit the present disclosure. Those skilled in the art to which the present disclosure pertains may make any modifications and changes in implementation forms and details without departing from the spirit and scope of the present disclosure, but the scope of protection of the present disclosure must be subject to the scope defined in the attached claims.

## Claims

1. A cellular structure of silicon carbide device, comprising:
a silicon carbide substrate of a first conductive type;
a drift layer of the first conductive type located above the substrate;
a plurality of well regions of a second conductive type which are arranged in a surface of the drift layer at intervals;
source regions, a source region of which is located in a surface of a well region;
gate trenches, a gate trench of which is positioned between two adjacent well regions; wherein a side wall of the gate trench is in contact with both the well region and the source region, and a depth of the gate trench is greater than a depth of the well region; and
shielding regions of the second conductive type which are located within the drift layer and arranged under the gate trench at intervals in a longitudinal direction; wherein top of a shielding region is in contact with bottom of the gate trench and bottom of the well regions.

2. The cellular structure of silicon carbide device according to claim 1, **characterized in that**,
the source region include a first source region of the first conductive type and second source regions of the second conductive type which are arranged in the first source region at intervals in the longitudinal direction;
wherein the first source region has its both ends in contact with side walls of gate trenches on both sides, respectively, and the second source regions are not in contact with the side walls of the gate trenches.

3. The cellular structure of silicon carbide device according to claim 2, **characterized in that**, the shielding regions under two adjacent gate trenches are arranged to be staggered from each other.

4. The cellular structure of silicon carbide device according to claim 2, further comprising:
storage regions of the first conductive type which are located under the gate trench;
wherein the storage regions and the shielding regions are arranged to be alternated with each other in the longitudinal direction, and top of a storage region is in contact with bottom of the gate trench and bottom of the well regions.

5. The cellular structure of silicon carbide device according to claim 1, **characterized in that**, the shielding regions under two adjacent gate trenches are arranged to be aligned with each other.

6. The cellular structure of silicon carbide device according to claim 5, **characterized in that**, the source region include first source regions of the first conductive type and second source regions of the second conductive type, which two are arranged to be alternated with each other in the longitudinal direction;
wherein the second source regions and the shielding regions are arranged to be aligned with each other in a transverse direction, and a first source region/a second source region has its both ends in contact with side walls of gate trenches on both sides.

7. The cellular structure of silicon carbide device according to claim 1, further comprising:
gate dielectric layers, a gate dielectric layer of which is arranged on side walls and bottom of the gate trench; and gates, a gate of which is filled in the gate trench;
a source metal layer located above the source regions and electrically connected with the source regions; wherein the gates are isolated from the source metal layer through interlayer dielectric layers, and the shielding regions are electrically connected with the source metal layer through the well regions and the source regions; and
a drain metal layer located under the substrate and forming an ohmic contact with the substrate.

8. A method for preparing a cellular structure of silicon carbide device, comprising:
providing a silicon carbide substrate of a first conductive type;
forming a drift layer of the first conductive type above the substrate;
forming a plurality of well regions of a second conductive type which are arranged at intervals in a surface of the drift layer;
forming a source region in a surface of a well region;
forming a gate trench between two adjacent well regions; wherein a side wall of the gate trench is in contact with both the well region and the source region, and a depth of the gate trench is greater than a depth of the well region; and
forming, by inclined ion injection, within the drift layer and under the gate trench shielding regions of the second conductive type which are arranged at intervals in a longitudinal direction; wherein top of a shielding region is in contact with bottom of the gate trench and bottom of the well regions.

9. The method for preparing a cellular structure of silicon carbide device according to claim 8, **characterized in that**, the source region includes a first source region of the first conductive type and second source regions of the second conductive type which are arranged in the first source region at intervals in the longitudinal direction; and the step of forming a source region in a surface of a well region comprises steps of:
forming a first source region of the first conductive type in a surface of the well region; wherein the first source region has its both ends in contact with side walls of gate trenches on both sides, respectively; and
forming second source regions of the second conductive type which are arranged in the first source region at intervals in the longitudinal direction; wherein the second source regions are not in contact with the side walls of the gate trenches.

10. The method for preparing a cellular structure of silicon carbide device according to claim 9, **characterized in that**, the shielding regions under two adjacent gate trenches are arranged to be staggered with each other.

11. The method for preparing a cellular structure of silicon carbide device according to claim 9, **characterized in that**, after the step of forming, by inclined ion injection, within the drift layer and under the gate trench shielding regions of the second conductive type which are arranged at intervals in a longitudinal direction, the method further comprises:
forming storage regions of the first conductive type under the gate trench;
wherein the storage regions and the shielding regions are arranged to be alternated with each other in the longitudinal direction, and top of a storage region is in contact with bottom of the gate trench and bottom of the well regions.

12. The method for preparing a cellular structure of silicon carbide device according to claim 8, **characterized in that**, the shielding regions under two adjacent gate trenches are arranged to be aligned with each other.

13. The method for preparing a cellular structure of silicon carbide device according to claim 12, **characterized in that**, the source region includes first source regions of the first conductive type and second source regions of the second conductive type, which two are arranged to be alternated with each other in the longitudinal direction; and
the step of forming a source region in a surface of a well region comprises steps of:
forming, in a surface of the well region, first source regions of the first conductive type and second source regions of the second conductive type, which two are arranged to be alternated with each other in the longitudinal direction;
wherein the second source regions and the shielding regions are arranged to be aligned with each other in a transverse direction, and a first source region/a second source region has its both ends in contact with side walls of gate trenches on both sides.

14. The method for preparing a cellular structure of silicon carbide device according to claim 8, **characterized in that**, after the step of forming, by inclined ion injection, within the drift layer and under the gate trench shielding regions of the second conductive type which are arranged at intervals in a longitudinal direction, the method further comprises:
forming a gate dielectric layer on side walls and bottom of the gate trench;
filling polysilicon into the gate trench to form a gate;
forming, above the gate, an interlayer dielectric layer covering the gate;
forming, above the source region, a source metal layer which is electrically connected with the source region; wherein the gate is isolated from the source metal layer through an interlayer dielectric layer, and the shielding region is electrically connected with the source metal layer through the well region and the source region; and
forming, under the substrate, a drain metal layer which is in ohmic contact with the substrate.

15. A silicon carbide device, comprising a plurality of the cellular structures of silicon carbide device according to any one of claims 1 to 7.
